# EUROPEAN PATENT SPECIFICATION

(11) **EP 4 495 803 B1**
(45) Date of publication and mention of the grant of the patent: **02.12.2026**
(21) Application number: 23306233.0
(22) Date of filing: 17.07.2023
(51) Int. Cl.: G06F 16/583, G06F 30/13, G06T 19/00

(54) **POSITIONING AN INPUT 3D OBJECT IN AN INPUT 3D SCENE**
POSITIONIERUNG EINES EINGABE-3D-OBJEKTS IN EINER EINGABE-3D-SZENE
POSITIONNEMENT D'UN OBJET 3D D'ENTRÉE DANS UNE SCÈNE 3D D'ENTRÉE

(43) Date of publication of application: 22.01.2025
(73) Proprietor: Dassault Systèmes, 78140 Vélizy-Villacoublay (FR)
(72) Inventor: MARCUSANU, Ana, VELIZY VILLACOUBLAY (FR)
(74) Representative: Bandpay & Greuter

(56) References cited:
- WO-A1-2021/263018

## Description

### TECHNICAL FIELD

The disclosure relates to the field of computer programs and systems, and more specifically to a method, system and program for automatically positioning an input 3D object representing a real object in an input 3D scene representing a room.

### BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA, 3DVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

In this context, applications for 3D scene completion are being developed. These applications generally propose to create, manipulate and furnish 3D scenes, especially (but not exclusively) for touch-sensitive devices (e.g., smartphone or tablet). One task of these applications is the computing of a consistent location for a given 3D object to be added to a partially furnished 3D scene.

In an attempt to tackle this task, most existing solutions include a step of position prediction for new items to add in the 3D scene. Referring to the list of prior art references hereinbelow, among these methods, several use deep learning algorithms such as references [1, 2, 3], others use data-driven and optimization techniques such as references [4, 5], and others implement a procedural approach relying on manually designed rules such as reference [6].

The methods described in references [1] and [2] use neural networks to predict the location of a previously predicted item to add in a 3D scene. In reference [1], the neural network takes as input the category of the object to add, a top-down view image of the room and some spatial constraints that the added object has to respect (e.g., add a TV with the constraint that it has to be in front of the bed). This method does not work well if the constraints are not consistent or cannot be fulfilled (e.g., if the bed is in front of a window or a wardrobe, the TV cannot be placed in front of it). In reference [2], the neural network takes as input the category of the object to add and a top-down view image of the room. Both methods in references [1] and [2] use a second neural network to predict the orientation of the object to add.

The method described in reference [3] uses a transformer neural network to complete 3D scenes. The transformer predicts the features of an object to add to the scene and four attribute extractors (MLP networks) predict its class, location, orientation and size in that precise order. If the class of the object is constrained, it will be able to predict a location, an orientation and a size for it and then select an object of the given class, closest in size, from a catalog and add it in the scene at the predicted location and orientation.

The methods described in references [1, 2, 3] consider only the category of objects and not the 3D models themselves, and this adds limitations to their use. For example, depending on how finely the classes are defined, it might not distinguish a table lamp from a floor lamp, a wall lamp or a ceiling lamp therefore predicting unsuitable positions for these objects. Moreover, they all rely on neural networks which can be a limitation for integration and deployment in an application. Indeed, algorithms based on deep learning require a specific infrastructure to be deployed.

The method described in reference [4] uses a genetic algorithm to optimize the layout of 3D furniture pieces inside a 3D room according to manually defined interior design KPIs (e.g., circulation or alignment). This method uses hand-defined rules and KPIs and the computation time can be quite long. This method is therefore unsuitable for end-user applications and for a catalog of furniture pieces that might evolve in time with new categories or objects added into it.

The method described in reference [5] uses a graph-based approach to furnish a 3D room with a given set of 3D furniture pieces. It groups objects together and computes the relative positions of objects inside groups using templates. The templates are obtained using a data-driven method based on relative positions of furniture classes in a 3D scene dataset. The position of the groups in the 3D room is then computed using an optimization algorithm. Since it considers furniture classes for the template computations, it relies on precise annotation of furniture.

Finally, reference [6] presents a procedural method for 3D scene generation based on handcrafted rules. Specifically, each 3D furniture of the dataset is annotated precisely with its class, dimensions and class-dependent location rules (e.g., "on the floor" for a sofa or "on object" for a plate). Templates are manually designed for groups of furniture classes that are common in indoor scenes (e.g., four chairs around a table). Then, several groups of objects are sampled and placed iteratively in the 3D room. This method heavily relies on handcrafted rules and templates which are defined at furniture class scale which presents the same drawbacks as the previous methods.

### List of prior art references:

[1] Wang, K., Lin, Y., Weissmann, B., Savva, M., Chang, A.X., & Ritchie, D. (2019). PlanlT: planning and instantiating indoor scenes with relation graph and spatial prior networks. ACM Trans. Graph., 38, 132:1-132:15.
[2] RITCHIE, Daniel, WANG, Kai, et LIN, Yu-an. Fast and flexible indoor scene synthesis via deep convolutional generative models. In : Proceedings of the IEEE Conference on Computer Vision and Pattern Recognition. 2019. p. 6182-6190.
[3] Despoina Paschalidou, Amlan Kar, Maria Shugrina, Karsten Kreis, Andreas Geiger, Sanja Fidler. 2021. ATISS: Autoregressive Transformers for Indoor Scene Synthesis. NeurIPS 2021*.*
[4] Peter Kan and Hannes Kaufmann. 2017. Automated Interior Design Using a Genetic Algorithm. In Proceedings of VRST2017, Gothenburg, Sweden, November 2017, 10 pages.
[5] Yang L., Zhang S., Zhang S., Xie W., Fu H. (2020). Fast 3D Indoor Scene Synthesis with Discrete and Exact Layout Pattern Extraction. arXiv:2002.00328v2
[6] Matt Deitke, Eli VanderBilt, Alvaro Herrasti, Luca Weihs, Jordi Salvador, Kiana Ehsani, Winson Han, Eric Kolve, Ali Farhadi, Aniruddha Kembhavi†, Roozbeh Mottaghi. 2022. ProcTHOR: Large-Scale Embodied AI Using Procedural Generation. NeurIPS 2022*.*
[7] Document EP4075316 A1.
[8] Scikit-learn library implementations of Gaussian Mixture Models and silhouette scores. https://scikit-learn.org/stable/modules/generated/sklearn. mixture.GaussianMixture.html https://scikit-learn.org/stable/modules/generated /sklearn.metrics.silhouette score.html

Also known is WO2021/263018A1, which discloses a method of augmenting scenes with virtual objects, the method including accessing a target scene, extracting features from the target scene into a spatial scene graph representation of the target scene, generating one or more datasets from the spatial scene graph representation, using machine learning system to iteratively operate on the one or more datasets to by sampling positions and orientations in the target scene to create a probability map for placement of a virtual object in the scene, and predicting a viable placement for tire virtual object in the target scene, producing a final scene.

Within this context, there is still a need for an improved solution for positioning an input 3D object in an input 3D scene.

### SUMMARY

The invention is defined by the appended claims.

### BRIEF DESCRIPTION OF THE DRAWINGS

Non-limiting examples will now be described in reference to the accompanying drawings, where:
- FIG. 1 shows a flowchart of an example of the method;
- FIG. 2 illustrates an example of a graph;
- FIG. 3 shows a flowchart of an example of offline and online stages;
- FIG. 4 illustrates examples of occurrences of pairs;
- FIG. 5 illustrates an example of counts;
- FIG. 6 illustrates an example of the determined respective positions;
- FIG.s 7 to 9 illustrate examples of fitting of the Gaussian mixture model;
- FIG. 10 illustrates an example of the ranking of the outputted pairs;
- FIG.s 11 to 22 show examples of positioning of input 3D objects;
- FIG. 23 shows an example of a graphical user interface of the system; and
- FIG. 24 shows an example of the system;

### DETAILED DESCRIPTION

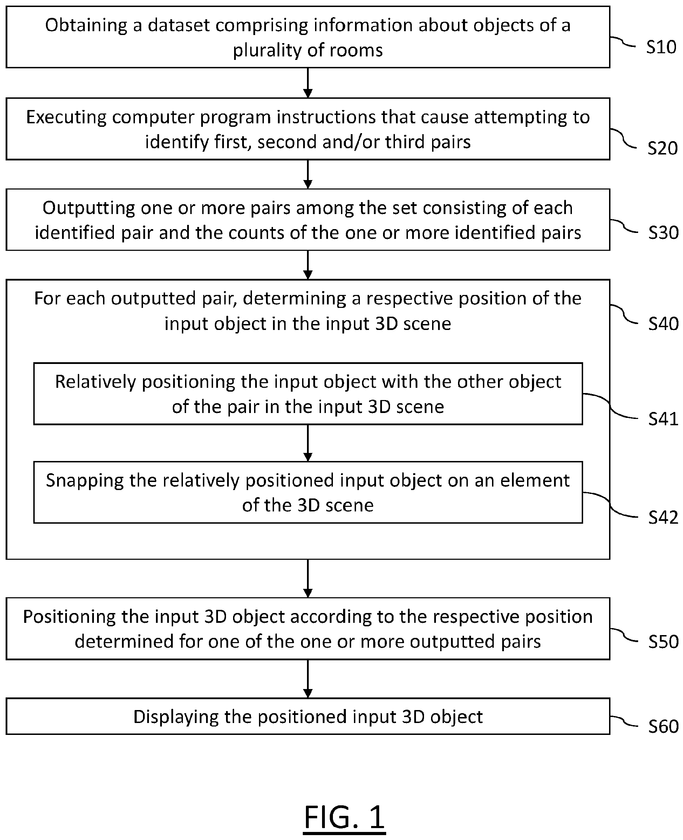

With reference to the flowchart of FIG. 1, it is proposed a computer-implemented method for automatically positioning an input 3D object representing a real object in an input 3D scene representing a room. The input 3D scene includes a plurality of positioned 3D objects. The plurality of positioned 3D objects includes positioned furniture 3D objects each representing a real piece of furniture. The method comprises obtaining S10 a dataset comprising information about objects of a plurality of rooms. The information includes a classification of the objects of the plurality of rooms. The information includes counts. Each count is a count of the set consisting of each occurrence of a respective pair including a same first real object and a same second real object in a room. The first real object and the second real object of each occurrence of each respective pair are arranged according to a mutual arrangement relationship from a predetermined set of one or more mutual arrangement relationships. The information includes information regarding the relative positioning of the first real object and the second real object in each occurrence of each pair.

The method comprises executing S20 computer program instructions that cause attempting to identify in the dataset one or more first pairs each including the input 3D object and a respective positioned 3D object of the input 3D scene. The executing of the computer program instructions causes, when no first pair is identified, attempting to identify in the dataset one or more second pairs each including only one of the input 3D object and a respective positioned 3D object of the input 3D scene, and an equivalent object for the other one. A given real object is an equivalent object for another given real object when the given real object has the same classification than the another given real object and the given real object is, among the set consisting of each real object of the same classification present in the dataset, the closest in size to the another given real object. The executing of the computer program instructions causes, when no first pair is identified and no second pair is identified, attempting to identify in the dataset one or more third pairs each including an equivalent object for the input 3D object and an equivalent object for a respective positioned 3D object of the input 3D scene.

The method comprises outputting S30 one or more pairs among the set consisting of each identified pair and the counts of the one or more identified pairs. The outputting is based on the set consisting of each count for a respective identified pair of the set consisting of each identified pair. The method comprises, for each outputted pair, determining S40 a respective position of the input 3D object in the input 3D scene based on the information regarding the relative positioning of the first real object and the second real object in each occurrence of the outputted pair. The method comprises positioning S50 the input 3D object according to the respective position determined for one of the one or more outputted pairs.

Such a method forms an improved solution for positioning an input 3d object in an input 3d scene.

Notably, the method allows computing a consistent position for an input 3D object in an input 3D scene based on the position of the furniture 3D objects in the input 3D scene. In particular, the computed position is consistent with respect to physical laws and interior design rules. Indeed, the counts of the pairs in the dataset allow statistically extracting these physical laws and interior design rules from the 3D scenes included in the dataset. The claimed method allows the positioning of the input 3D object in a way that respects physical constraints of objects statistically determined on the 3D scenes of the dataset. For example, the method allows computing the positioning of a bedside lamp on the top surface of a bedside table, of a cushion on top of a bed, or of a picture on a wall above the headboard. This is particularly useful (but not exclusively) for touch-screen devices in which the handling of 3D environments can be difficult.

Moreover, the claimed method is data-driven and does not rely on neural networks. This is an advantage for its integration in an existing application using a current infrastructure. It is also fast in inference which allows for instantaneous use from the user standpoint (locations computation takes only approximately 1 second). Indeed, the method identifies the pairs simply by going through the pairs in the dataset, and may output the pairs only from the statistics of the counts. The method is therefore based solely on identifying similar pairs and comparing the number of occurrences of each pair (this comparison being rapid because it is based on numbers). These statistical considerations are necessarily less computationally-intensive (and therefore faster) than using a neural network, which is necessarily more computationally-intensive to implement. The claimed method is therefore more efficient and less demanding in terms of computer resources. This is an advantage because, for end-users applications, the method has to be fast, so that the insertion seems instantaneous.

Furthermore, the claimed method allows considering the exact 3D model to add into a 3D scene without abstracting it to its classification, when possible. Indeed, the executed computer program instructions allow considering first the pairs of same input 3D objects. Moreover, the claimed method also allows such an abstraction if needed. Indeed, the executed computer program instructions allow considering second and third pairs of equivalent objects when no first pair is identified. Therefore, the claimed method allows an adapted search of similar pairs depending on the classification or not of the input 3D objects, which improves the relevance of the computed positionings.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

For examples, the method may comprise, prior to the executing S20, a step of selecting of the input 3D object to be positioned. The selection may be done from a virtual catalog containing a plurality of potential input 3D objects. This virtual catalog may be updated by manufacturers of objects (e.g., each time a new product is launched). For example, the virtual catalog may be stored in a database (e.g., available online), and each manufacturer may upload the objects they manufacture to the catalog. The selection may be performed by a user, e.g., currently designing the room. The selection may be performed in the virtual catalog in any manner. For example, the user may select one of the objects in the catalog using an object reference. Alternatively or additionally, the method may comprise displaying the objects of the catalog (e.g., with filters on the classification of the objects), and the user may select one of the displayed objects (e.g., by performing a user interaction on it, for example a touch with a finger or stylus when the objects are displayed on a touch screen or a touch pad, or, a mouse click when the user uses a mouse).

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g., one for the program, and possibly one for the database). Optionally, the system may comprise a touch-screen or a touch-pad. The touch-screen or the touch-pad may be coupled to the processor and the memory. The user may perform user-interactions on touch-screen or the touch-pad. The method may display the GUI (e.g., including the 3D scene) on the touch-screen or the touch-pad.

The dataset may be stored in a database. By "database", it is meant any collection of data (i.e., information) organized for search and retrieval (e.g. a relational database, e.g. based on a predetermined structured language, e.g. SQL). When stored on a memory, the database allows a rapid search and retrieval by a computer. Databases are indeed structured to facilitate storage, retrieval, modification, and deletion of data in conjunction with various data-processing operations. The database may consist of a file or set of files that can be broken down into records, each of which consists of one or more fields. Fields are the basic units of data storage. Users may retrieve data primarily through queries. Using keywords and sorting commands, users can rapidly search, rearrange, group, and select the field in many records to retrieve or create reports on particular aggregates of data according to the rules of the database management system being used.

The method generally manipulates modeled (3D) objects. A modeled object is any object defined by data stored e.g. in the database. By extension, the expression "modeled object" designates the data itself. According to the type of the system, the modeled objects may be defined by different kinds of data. The system may indeed be any combination of a CAD system, a CAE system, a CAM system, a PDM system and/or a PLM system. In those different systems, modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a modeled object may be defined by data corresponding to any combination of these systems. A system may thus well be both a CAD and PLM system.

By CAD system, it is additionally meant any system adapted at least for designing a modeled object on the basis of a graphical representation of the modeled object, such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones.

In the context of CAD, a modeled object may typically be a 3D modeled object, e.g. representing a real object positioned (or to be positioned) in a real room (e.g., a furniture object or a decorative object). By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. Any 3D modeled object may be a CAD object, e.g., comprising a mesh or a B-rep (e.g., resulting from computations defined in a history of geometrical features).

Each 3D object may represent the geometry of a real object positioned (or to be positioned) in a real room. The real object may be manufactured in the real world subsequent to the completion of its virtual design (e.g., using a CAD software solution or a CAD system). The method considers a classification of objects, and each object (real or its 3D representation) may belong to a class of objects in this classification. The classification may include a class for each category of objects generally present in a room. The dataset includes the classification of the objects of the plurality of rooms (e.g., the dataset may comprise a label for each object present in each room, the label indicating the class to which the object belongs). The input 3D object may also belong to a class of the same classification. The classification may comprise classes of furniture objects and classes of decorative objects. Each room (in the dataset and the one represented by the input 3D scene) may comprise one or more furniture objects. Each room may also comprise one or more decorative objects. The input 3D object may be a decorative object, and the method may position this decorative object with respect to one of the other 3D objects of the 3D scene (a decorative object or a furniture object).

In examples, the room represented by the input 3D scene and/or the rooms of the dataset may be indoor rooms. For examples, the room represented by the input 3D scene and/or the rooms of the dataset may comprise rooms in a dwelling (e.g., a house or apartment), such as kitchens, bathrooms, bedrooms, living rooms, garages, laundry rooms, attics, offices (e.g. individual or shared), meeting rooms, child rooms, nurseries, hallways, dining rooms and/or libraries (this list may include other types of rooms). Alternatively or additionally, the room represented by the input 3D scene and/or the rooms of the dataset may comprise other indoor rooms, such as factories, museums and/or theaters. Alternatively or additionally, the room represented by the input 3D scene and/or the rooms of the dataset may comprise outdoor scenes, such as gardens, terraces or amusement parks.

Any furniture object herein may have a furnishing function in the room where they are placed. For examples, the classification may comprise any combination of one or more chair classes, one or more lamp classes, one or more cabinet classes, one or more shelve classes, one or more sofa classes, one or more table classes, one or more bed classes, one or more sideboard classes, one or more nightstand classes, one or more desk classes and/or one or more wardrobe classes. For example, the classification may comprise any combination of classes each for a respective one of the following objects: separators, walls, air conditioners, armchairs, wardrobes, bars, base cabinets, mirrors, single sinks, double sinks, sinks, storage, bathtubs, bookcases, sideboards, bunk beds, ceiling lights, children's beds, fireplace tools, clothes organizers, shoe organizers, coffee tables, cooktops, desks, chairs, tables, beds, double beds, dressers, dryers, electrical switches, TV, electronics and entertainments, home cinemas, faucets, fireplaces, fitness equipment, floor lamps, freezers, headboards, high cabinets, home automations, intercoms, house alarms, hoods, islands, junior chairs, lightings, microwaves, nursery, changing tables, beds, cribs, pergolas, gazebos, playgrounds, plumbing, pools, radiators, ranges, refrigerators, shelves, shower columns, shower doors, showers, side tables, single beds, sofas, stools, table lamps, toilets, media furniture, wall cabinets, wall lamps, wall shelves, washers, benches, sun loungers, ovens, dishwashers, nightstands, vehicles, mailbox, trees, front doors, security doors, patio doors, screen doors, simple interior doors, double interior doors, sliding doors, interior doors, interior openings, garage doors, service doors, simple windows, double windows, simple sliding windows, double sliding windows, basement windows, fixed windows, skylights, stairs, outdoor activities, poufs, wall stickers, dressing tables, wood burning stoves, oven cabinets, under sink cabinets, sliding storage, corner cabinets, safety detectors, openings, fountains, bridges, wells, columns, water heaters, furnaces, boilers, barbecues, gardening, patio heaters, helical stairs, straight stairs, quaterturn stairs, double quaterturn stairs, kitchen sets, folding doors, push windows, bay windows, railings, platforms, cupboards, mattresses, wine cellars, suspended lamps, meridians, footstools, showcases, leisure chairs, office chairs, bed stools, outdoor sofas, outdoor chairs, outdoor benches, outdoor tables, swinging patio doors, sliding patio doors, bathroom mirrors, children desks, children bedroom furniture, gates, garden lounges, straight sofas, corner sofas, modular sofas, armless chairs, four poster beds, mezzanine beds, floor standing mirrors, wall mirrors, kitchen accessories, baby bathtubs, bathroom base cabinets, bathroom columns, bathroom vanity units, cradles, garden lightings, balconies, fronts, doors, double doors, double glass doors, drawers, glass doors, cabinet shelves, filler strip angle, wall panels, free standing filler strips, wall panel edges, roof windows and/or half height cabinets.

Any decorative object herein may have a decorative function in the room where they are placed. For example, the classification may comprise any combination of one or more accessory classes, one or more plant classes, one or more book classes, one or more frame classes, one or more kitchen accessory classes, one or more cushion classes, one or more lamp classes, one or more curtain classes, one or more vase classes, one or more rug classes, one or more mirror classes and one or more classes for electronic objects (e.g., refrigerator, freezer and/or washing machine). For example, the classification may comprise any combination of classes each for a respective one of the following objects: accessories, mirrors, blinds, ceiling lights, fireplace tools, curtains, decorative accessories, plugs and meters, electronics and entertainments, Hifi, fences, floor lamps, smoke detectors, lightings, decorations, people, plants and flowers, rugs, table lamps, toys, wall decorations, wall lamps, small appliances, aquarium, coat stands, vases, kids activities, beams, towel holders, poufs, screens, trash cans, frames, candles, candlesticks, paintings, books, kids' mobiles, height charts, weathercocks, statues and sculptures, clocks, posters, swings, sandboxes, trampolines, kitchenware, tableware, pet's stuffs, ornaments, suspended lamps, tapestries, towel-dryers, toboggans, hammocks, carpets, hardwoods, wallpapers, paints, vinyl, tiling, mosaics, stones, slates, bricks, concretes, marbles, linoleums, shingles, fiberboards, wall clothes, cobblestones, cushions, bathroom mirrors, wainscot, decking tiles, decking, do-it-yourself articles, filler strips, security products, floor standing mirrors, wall mirrors, bathroom accessories, office supplies, children decorations, outdoor decorations, garden lightings, beach umbrellas, gravel, parging, worktops, plinths, boxes, legs, wall tiles, joint, operation, wall edge strips, deco strips, quartz, resources, cornices, countertop edges, drainer grooves, wall edge strip edges, cover panels and/or handles.

The rooms of the plurality of rooms may comprise (i.e., grouping together all the objects in each room) objects that belong to a number of classes of the classification (these classes being thus represented in the dataset). For example, the rooms of the plurality of rooms may comprise at least one object belonging to each class of the classification (each class of the classification being represented in that case). The classification may have been determined for including a class for each category of objects in the different rooms of the dataset. The input 3D scene may also comprise objects that belong to another number of classes in the classification (this number being less than the number of classes represented in the plurality of rooms in the dataset, but being for example on average equivalent to the number of classes represented in each room in the dataset). For example, each object of the input 3D scene may belong to a class which is represented in the dataset.

The method is included in a real-life room design (i.e., effective arrangement) process, which may comprise, after performing the method, using the input 3D scene to illustrate a room to be arranged (from scratch or by adding the object represented by the input 3D object in an already furnished and/or decorated room for example). For example, the illustration may be for a user such as the owner of the home in which the room is located. The illustration may comprise determining images and/or videos of the input 3D object positioned inside the input 3D scene. The determined images and/or videos may be used by the user for deciding whether or not to acquire the object, and may assist the user's choice by showing the object in the room. During the real-life room design process, the method is repeated for placing different objects inside the input 3D scene. The repetition of the method may be used to illustrate a complete virtual interior of the room (with several objects positioned using the method).

Alternatively or additionally (e.g., prior to the illustration), the real-life room design process may comprise populating an input 3D scene representing a room with one or more decorative objects. The populating may comprise repeating, for each decorative object, the method for positioning a respective input 3D object representing the decorative object in the input 3D scene. The real-life room design process allows creating richer, more pleasant environments (for animation, advertising and/or for generating virtual environments, e.g. for simulation). The real-life room design process may be used for generating virtual environments (e.g., metaverse). The real-life room design process may be included in a general process which may comprise repeating the real-life room design process for several input 3D scenes, thereby populating a set of input 3D scenes with decorative objects.

Alternatively or additionally (e.g., after the populating), the real-life room design process comprises evaluating one or more layout metrics on the room represented by the input 3D scene. The one or more layout metrics include a circulation metric, a brightness metric, an accessibility metric (e.g., representing an ability to use functional furniture) and/or an ergonomics metric. The real-life room design process comprises using these evaluated one or more metrics to ensure ease of movement in the room, accessibility of certain objects, safety and/or a certain level of ergonomics in the room (e.g., a room to be built later).

Alternatively or additionally, the real-life room design process comprises, after the performing of the method, physically arranging a (i.e., real) room so that its design matches the input 3D scene. For example, the room (without the object represented by the input 3D scene) may already exist in the real world, and the real-life room design process may comprise positioning a real object represented by the input 3D object inside the already existing room (i.e., in the real world). The real object is positioned according to the position computed by the method. The method being repeated for positioning different 3D objects, the real-life room design process comprises positioning different real objects inside the room. Alternatively, the room may not already exist at the time the method is executed. In that case, the real-life room design process may comprise building a room according to the provided 3D scene (i.e., starting from scratch and by placing objects as in the provided 3D scene). Because the method improves the positioning of the 3D objects in the 3D scene, the method also improves the building of a room corresponding to the 3D scene and thus increases productivity of the real-life room design process.

The method may comprise a step of forming the dataset (dataset-forming step) from the plurality of rooms. In that case, the obtaining S10 may comprise the dataset-forming step. The dataset-forming step may be simple and fast. For example, the dataset-forming step may comprise a single loop to go through the dataset, counting each pair of objects and recording their relative positioning. The forming of the dataset may be completely automated (i.e., without manual intervention).

The dataset-forming step may comprise determining the information about the objects of the plurality of rooms (i.e., the classification, the counts and/or the information regarding the relative positioning in each occurrence of each pair). For example, the dataset-forming step may comprise counting the occurrences of pairs in the plurality of rooms. After the dataset-forming step, the obtaining S10 may comprise recording the computed dataset in the database, and step S20 may be executed by accessing the recorded dataset. The plurality of rooms may be recorded, for example on the same database or on another database. The computing of the dataset may be done by consulting the recorded plurality of rooms.

Alternatively, the method may comprise retrieving the dataset in a database. The dataset may optionally in such a case have been obtained according to the above dataset-forming step (prior to the executing of the method). In that case, the obtaining S10 may comprise providing an access to the dataset in the database. The method may use this access to identify the first, second and/or third pairs in the dataset (during step S20).

The computing of the dataset (i.e., the dataset-forming step) may be performed during an offline stage. In that case, the computed dataset may for example be recorded in the database during this offline stage. The dataset may for example be computed by a server having access to information about the plurality of rooms (e.g., 3D representations of these rooms). Then, the steps S20 to S50 (and step S10 when the dataset is already computed) may be performed during an online stage. For example, these steps may be executed by a client computer having access to the dataset computed during the offline stage.

The method may comprise updating the dataset (e.g., regularly). For example, manufacturers may add new objects in the catalog, e.g., by adding new rooms (that include these new objects) in the database, and the method may update the dataset for including these new objects. In that case, the updating may comprise determining new pairs that include these new objects. Then, the method may comprise counting the occurrences of these new pairs, and including the counts of occurrences of these new pairs (with their relative positions) in the dataset. It improves efficiency because the dataset is updated only for the new objects to add (without recomputing the statistics for the pairs of the already present objects).

The objects and the rooms in the dataset may or could exist in the real world (already now at the time of the computing of the dataset or in the future). For example, the rooms may be actual real rooms (in terms of layout) of the real world, and the objects may be positioned inside these real rooms as specified in the information of the dataset. The plurality of rooms may comprise rooms that have been designed (for example by interior designers), and then implemented in the real world (i.e., the plurality of rooms corresponds to virtually designed rooms that have been, or could be, reproduced in people's homes). In examples, each room of the dataset is of the same type as the room represented by the input 3D scene. For example, all the rooms of the dataset may be kitchens, bathrooms, bedrooms, living rooms, garages, laundry rooms, attics, offices (e.g. individual or shared), meeting rooms, child rooms, nurseries, hallways, dining rooms or libraries (this list may include other types of rooms). It allows providing more precise positions and increases stability of the method.

The classification of the objects of the plurality of rooms may include the class (i.e., the category) to which the object belongs. The category may be one of the categories listed above for each furniture or decorative objects. The classification may be determined during the computing of the dataset. For example, the computing may comprise determining the classification of the objects of the plurality of rooms according to a predetermined list of classes of objects. The determining of the classification may comprise identifying to which class each object of each room belongs.

The information of the dataset also includes the counts of the pairs. Each count may be the number of elements in the set consisting of each occurrence of a respective pair including a same first real object and a same second real object in a room. By same real object, it is meant an object that has the same properties as the one in each other occurrence. For example, the object may have the same geometry (e.g., external envelop, texture and/or color) in each other occurrence of the respective pair and/or may be the same product manufactured by the same manufacturer (e.g., may have the same product reference). The respective set may comprise one or more occurrences of the respective pair. The respective set may comprise occurrences of pairs in a same room, and/or occurrences in different rooms of the plurality (i.e., one for each respective room). The information includes a respective count for each pair (in the same room and in different rooms). The count is the number of occurrence(s) of the respective pair (for example the count having a value of *n* when the plurality of rooms contains *n* occurrence(s) of the respective pair, wherein *n* is an integer). The pairs of the dataset may comprise one or more pairs each including a decorative object and a furniture object (the decorative object and the furniture object being arranged according to a mutual arrangement relationship in one or more rooms of the plurality). Alternatively or additionally, the pairs of the dataset may comprise one or more pairs each including a decorative object and another decorative object (the two decorative objects being arranged according to a mutual arrangement relationship in one or more rooms of the plurality).

For each occurrence of each pair, the mutual arrangement relationship between the first real object and the second real object is one of the one or more mutual arrangement relationships of the predetermined set. Each mutual arrangement relationship specifies a particular type of spatial arrangement between the first and second real objects in the room (i.e., in terms of positions and orientation of the first and second real objects). The spatial arrangements between objects may be categorized (e.g., in the front, to the side, or one above the other), and the predetermined set may comprise a mutual arrangement relationship for each category.

In examples, the occurrences of the pairs for a same room may be represented in a graph, which may comprise nodes representing the objects of the room, and edges each linking a respective pair of two nodes. Each edge may represent a respective occurrence of a pair between the two nodes linked by the edge. Each edge may comprise a label indicating the mutual arrangement relationship between the two objects represented by the nodes linked by the edge. The computing of the counts may be based on these graphs. For example, the method may count the occurrences of same pairs in the plurality of rooms by browsing the graphs of the plurality of rooms. The dataset may comprise the respective graph of each room of the plurality of rooms. In that case, the computing of the counts may be based on these graphs. Alternatively, the graphs may be recorded in a database, and the method may carry out the computing of the counts by accessing this database.

In examples, the predetermined set may comprise an adjacency relationship. Two objects may be arranged according to the adjacency relationship when they are spaced from each other by less than a predetermined distance (e.g., 5 centimeters). For example, the distance may be the distance between bounding boxes representing the two objects in a 3D scene representing the room (e.g., a distance defined along one of the axes of one of the two objects). Alternatively or additionally, the predetermined set may comprise a vertical superposition relationship. Two objects may be arranged according to the adjacency relationship when they are positioned one above the other (e.g., a lamp on the ceiling that is located above a table).

The information of the dataset also includes the information regarding the relative positioning of the real objects in each occurrence of each pair. The information may include, for each occurrence, a respective relative positioning of the real objects. The relative positioning may be in the form of a vector having coordinates representing the distance between the first object and the second object in the different directions of a coordinate system (e.g., between bounding boxes representing the two objects or between a center of these bounding boxes). Alternatively, the information may be a general information about all occurrences. For example, the information may include an average of the relative positionings of the real objects in all the occurrences (e.g., an average of the said vectors).

The computer program instructions executed at step S20 may be recorded on a memory. The computer program instructions are instructions to perform the identification of the pair(s) in the dataset. The computer program instructions may be a block of data representing an algorithm and capable of generating different sequences of steps depending on the situation, in particular depending on whether the "when" conditions are verified or not. The exact steps in the method therefore depend on the situation. In one example, the method executes all the branches of the algorithm (i.e., all the attempting to identify) at least once. Attempting to identify means launching a process which runs and whose final result depends on the situation. For example, the final result may be the output of the identified pairs if there are any, and otherwise if there are none, may be performing nothing or outputting of a "fail" message.

The executing S20 may comprise providing one or more pairs among all the pairs of the dataset (the one or more pairs being the one or more pairs identified during the executing of the computer program instructions). The computer program instructions cause three successive identification attempts: the first identification attempt searches the pairs with the same objects, the second identification attempt searches the pairs with only one of the two objects of the pair (and an equivalent for the second) and the third identification attempt searches the pairs with equivalent objects. The computer program instructions may comprise instructions for each of these identification attempts (although not all of these identification attempts are always executed). The executing S20 starts with executing of the first identification attempt. When at least one first pair is identified, the second and third identification attempts are not performed, and the identified pair(s) are the identified first pair(s). Otherwise, the second identification attempt is performed. In that case, when at least one second pair is identified, the third identification attempt is not performed, and the identified pair(s) are the identified second pair(s). Otherwise, the third identification attempt is performed, and the identified pair(s) are the identified third pair(s) (the dataset may always comprise at least one third pair).

The outputting S30 is performed based on the pair(s) identified during the executing S20. The outputted pair(s) are among the identified pair(s). For example, the outputted pairs may comprise all the identified pairs. Alternatively, the outputted pair(s) may comprise each identified pair that has a count higher than a predetermined number. In that case, each outputted pair may have a count higher than this predetermined number (e.g., a predetermined number higher than 5 or 10 and/or lower than 15 or 20). In that case, the outputting S30 may comprise filtering the identified pair(s) based on their count, thereby outputting only the pair(s) having a count higher than the predetermined number. Alternatively, the number of outputted pair(s) may be predetermined, and the outputting S30 may comprise selecting a predetermined number of pair(s) from those identified (the outputted pairs being those selected). In that case, the selection of the predetermined number of pair(s) may be based on the counts of the identified pair(s). For example, the outputting S30 may comprise ranking the identified pair(s) according to their count and selecting the predetermined number of pair(s) ranked first (e.g., the *k* pairs ranked first, wherein *k* is an integer, e.g., higher than 1 and/or lower than 10, e.g. equal to 5) (the outputted pairs being the *k* pairs ranked first).

After the outputting S30, the method comprises, for each outputted pair, the determining S40 of a respective position of the input 3D object. The determined respective position may be different for each outputted pair. For each outputted pair, the determined respective position may be such that the object is positioned in the same way as in each occurrence of the outputted pair (e.g., on average). For example, when the outputted pair is a first pair, the input 3D object may be the same as one of the 3D objects of the pair, and the 3D scene may include a given object that is the same as the other object in the pair. In that case, the determined respective position may be such that the input 3D object is positioned with respect to the given object as the two objects in occurrences of the pair. The same may apply when the outputted pair is a second or third pair with equivalent object(s) (for the input 3D object, the given object, or both objects). The outputting S30 and determining S40 steps may be fast. For example, the method may complete the outputting S30 and determining S40 steps in as little as one second. When the positioning S50 is performed automatically, the method may compute the position for the input 3D object (i.e., including performing the outputting S30 and determining S40 steps) in just one second in total.

After the determining S40, the method comprises the positioning S50 of the input 3D object. The positioning S50 of the input 3D object is performed according to the respective position determined for one of the one or more outputted pairs. When the method outputs only one pair, the method may position the input 3D object in exact compliance with the relative positioning determined for this only one outputted pair. Alternatively, the method may output several pairs. In that case, the method may comprise, prior to the positioning S50, selecting the pair (among those outputted) from which the object is positioned. For example, the selection may be random. Alternatively, the selection of the pair may be performed by a user. In that case, the selecting may comprise performing a user-interaction for selecting one of the displayed positions. For example, the method may comprise displaying a set of different icons or graphisms each associated with a respective position, and the selection may be performed by the user by performing a user interaction on it (e.g., a touch with a finger or stylus when the icons or graphisms are displayed on a touch screen or a touch pad, or, a mouse click when the user uses a mouse) by clicking on one of the displayed icons. Alternatively yet, the selection may be performed according to a position specified by the user (e.g., also based on a touch or a click). In that case, the selected position may be the position which is the closest to the position specified by the user.

Alternatively, the selection of the pair may be automatic. For example, the outputted pairs may be ranked (e.g., according to their count), and the outputted pair from which the input 3D object is positioned may be the one having the highest ranking. In that case, the method may further comprise, prior to the positioning S50, ranking the outputted pairs according to the count of the outputted pairs in the dataset, and automatically selecting the outputted pair having the higher ranking (i.e., the higher count) (the automatically selected pair being the one from which the input 3D object is positioned). When at least two pairs have the highest ranking, the method may randomly select one of them.

After the positioning S50, the method may comprise displaying S60 the positioned input 3D object (i.e., in the input 3D scene and with each other 3D object of the input 3D scene). In examples, the method may repeat the positioning S50 and displaying S60 steps. For example, the method may repeat the positioning S50 each time the user selects a new position for the input 3D object among the outputted pairs. For example, the method may repeat the positioning S50 each time the user selects a new icon (when the selection of the position is performed via a displayed set of icons) or moves the cursor to a new position (when the selection is performed using the cursor). In that case, the method may repeat the display S60 of the input 3D object in the new selected position.

In examples, for each outputted pair, the determining S40 may be performed in two steps. In a first step, the determining S40 comprises relatively positioning S41 the input 3D object with the other object of the pair in the input 3D scene based on the information regarding the relative positioning of the first real object and the second real object in each occurrence of the outputted pair. For example, the method may relatively position the input 3D object as an average across all the occurrences of the outputted pair. In that case, the method may comprise determining an average relative positioning of the two objects in all the occurrence of the outputted pair (e.g., considering an average value for each axis of a coordinate system), and may relatively position the input 3D object with the other object of the pair in the input 3D scene as according to this average relative positioning.

Alternatively, when the information regarding the relative positioning of the first real object and the second real object in each occurrence of the outputted pair comprises a respective relative positioning for each occurrence, the method may further comprise, prior to the relatively positioning for each outputted pair, fitting parameters of a Gaussian mixture model to the relative positioning of objects in the occurrences of the pair. For example, the Gaussian mixture model may comprise a respective parameter for each coordinate of a coordinate system (this coordinate system being defined relatively to one of the objects of the pair, e.g., the one already present in the scene to calculate the position of the one to be added, this object being the same for each occurrence). In that case, the relatively positioning may comprise sampling in the distribution represented by the Gaussian mixture model for the fitted parameters (the relative position of the input 3D object corresponding to the relative position sampled in the distribution). The sampling allows taking into account the variability of the dataset. One advantage of the Gaussian mixture model compared with simple position averaging is the identification of several Gaussian components (as illustrated in the examples in FIG.s 7 and 8). It also allows providing new positions for the input 3D object. For example, the method may repeat the sampling, thereby providing a new relative position for the input 3D object at each repetition (the new relative position being among the distribution).

In a second step, the determining S40 comprises snapping S42 the relatively positioned input 3D object on an element of the 3D scene. The snapping may be performed as known in the art. The snapping comprises automatically sticking the input 3D object on the element of the 3D scene while staying within the relatively positioning determined in the previous step S41.Tthe snapping comprises determining the element of the 3D scene on which the input 3D object is snapped, and then snapping the input 3D object on this determined element. The determined element depends on the category of the input 3D object, and is the closest to the positioned input 3D object. For example, the determined element may be the ceiling when the input 3D object is a ceiling lamp or may be the closest wall when the input 3D object is a mural object (such as wall lamps, frames, wall mirrors). In all other cases, the method may snap the inserted object to the closest horizontal surface (e.g., the floor, the top of a shelf or a furniture shelf) to account for gravity, modifying only the z coordinate of the input 3D object. The snapping enhances the realism of the provided position.

In examples, for each outputted pair, the respective position of the input 3D object in the input 3D scene determined for the outputted pair has no conflict with any other 3D object of the plurality of positioned 3D objects of the input 3D scene. The determination of the conflict comprises: 1) verifying that an intersection between the input 3D object and all other 3D objects in the input 3D scene (e.g., except the object relative to which the input 3D object is positioned) is zero, or 2)each 3D object of the input 3D scene being represented by a respective bounding box, verifying that an intersection between the bounding box representing the input 3D object and the bounding box representing any other 3D object of the input 3D scene is zero. A bounding box for a 3D object may be the box with the smallest measure (area or volume) within which all the points of the 3D object lie. To achieve this, the method may comprise filtering the identified pair(s) (at step S20), so that all those for which an intersection is identified are discarded. The method may perform this filtering prior to the ranking of the identified pair(s), and may ignore the discarded pair(s), so that only pair(s) providing non-intersecting position of the input 3D object may be present in the outputted pair(s).

With reference to FIG.s 2 to 24, examples of implementation of the method are now discussed.

The method computes consistent locations for an input 3D object to add in a 3D scene. The method computes positions for what is called decorative objects (unlike functional objects). Positions of decorative objects depend on other objects (i.e., functional objects as well as decorative objects) already present in the room (e.g., a table lamp is located on a table/desk/nightstand).

The method is based on statistics computed on a dataset of 3D (e.g., indoor) scenes (representing the plurality of rooms) and their corresponding extracted scene graphs as defined in EP4075316 A1 (reference [7]) and which is incorporated herein by reference. The method uses frequent locations for decorative objects with respect to the other objects in the room to compute consistent locations for a new 3D decorative furniture to add in the 3D room.

The method may proceed in two stages. The first stage may be an offline stage for the computation of the statistics used for the rest of the pipeline on a given 3D scenes dataset. In this stage, the method may use the scene graphs (e.g., the graphs discussed in reference [7]) of the 3D scenes in the dataset to compute occurrences of decorative-functional objects pairs and optionally of decorative-decorative objects pairs organized by classes. The method may also gather the relative positions of each pair as seen in the dataset into a relative positions dictionary.

The second stage may be an online stage for the computation of locations for a given 3D decorative object (i.e., the input 3D object) to add in a 3D scene (i.e., the input 3D scene). In this step, the method first comprises selecting potential "anchors" among the other 3D objects already present in the 3D scene. For each of these candidate anchors, the method may comprise computing a location based on the relative positions dictionary. These positions are then refined to be valid physically and ranked. The added object is then inserted into the 3D scene at the first location or by means of a user interaction where the user selects one location among all outputted locations.

The notion of 3D scene is now discussed. A 3D scene may comprise a 3D layout (i.e., the geometry of the environment: set of walls and boundaries, positions and dimension), a collection of 3D objects (i.e., a set of CAD models with their size, position and orientation in 3D space) with semantic annotations such as their type (e.g. chair, table, sofa...), a model ID and a function type ("functional", "decorative" or both), and, optionally, a set of 3D openings (i.e. the doors and windows in the environment). These 3D openings can also be treated as 3D objects among others.

The method considers a classification of the 3D objects between two classes: functional and decorative. The functional objects are room-defining objects which are usually placed in a room with respect to the room's architecture (walls and openings). They are usually bigger and important for the room's use (e.g., a bed in a bedroom or a sofa in a living room). The decorative objects are not room-defining and are used for decoration and creating an atmosphere without altering the room's function. Decorative objects are usually placed in a room with respect to the other objects (e.g., a cushion on a sofa or a lamp on a nightstand). Some objects are both considered as functional and decorative (e.g., lamps and mirrors). The method may concern the automatic positioning of decorative objects inside a partially furnished room.

Each 3D scene may be associated with its corresponding scene graph. These scene graphs are for example discussed in reference [7]. The scene graphs represent spatial relationships between the 3D elements (the 3D elements include walls, openings and objects) in the 3D scene. The scene graphs contain the essential spatial relationships between the elements in the scene representing the most meaningful and functional constraints.

A scene graph may be structured as follows. The scene graph may comprise a list of nodes that each corresponds to a 3D element in the room. Each node may comprise the following attributes: the node ID, the category of the 3D element, the 3D bounding box of the 3D element (length, width and height), the transformation matrix of the 3D element (to obtain the absolute position and orientation in the 3D room of the 3D element), the corresponding 3D model for each 3D element, the 3D element's macro category (optional), the list of ingoing edges, the list of outgoing edges, parent(s) and/or superstructure tag if any (e.g., "is_hub", "is_spoke", "is_chain"). The scene graph may comprise a list of edges to represent the relations between the 3D elements in the room. Each edge may comprise the following attributes: an edge ID, the ID of the starting node, the ID of the ending node, a direction (e.g., "front", "back", "left", "right", "support"), an optional tag (e.g., "contained"), a functionality (optional), a distance tag, the distance exact value between the bounding box of the starting node of the edge and the bounding box of the ending node and/or superstructure tag if any (e.g., "is_spoke", "is_chain"). The distance tag may for instance be "adjacent" if the minimal distance between the bounding box of the starting node of the edge and the bounding box of the ending node of the edge is less than an "adjacent" threshold (e.g., 5cm). The distance tag may for instance be "proximal" if the minimal distance between the bounding box of the starting node of the edge and the bounding box of the ending node of the edge is greater than the "adjacent" threshold and less than another "proximal" threshold (e.g., 50cm). The distance tag may for instance be "distant" if the minimal distance between the bounding box of the starting node of the edge and the bounding box of the ending node of the edge is greater than the "proximal" threshold.

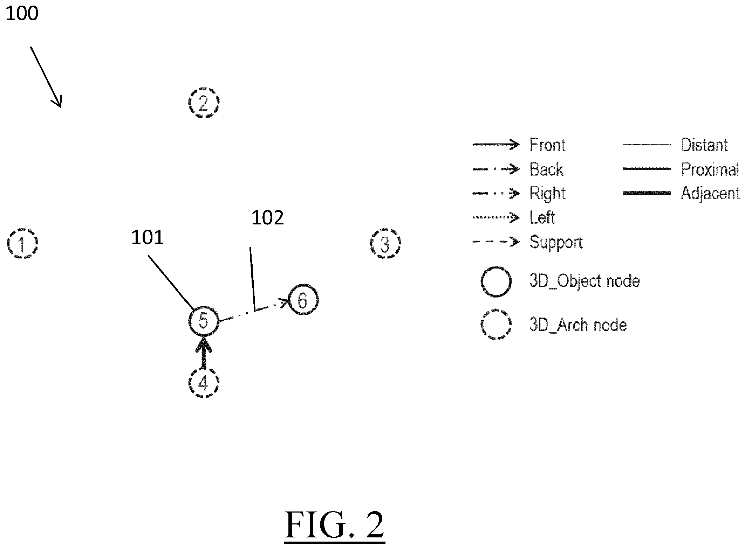

FIG. 2 illustrates an example of graph 100 of a room. In this example, the attributes are as follows. For the "node5", the attributes are "category": "Double beds", "macro-category": "bed", "transformation_matrix": [0, 1, 0, 0, -1, 0, 0, 0, 0, 0, 1, 0, -13302.5, -5203.2, 455.0, 1], "bounding_box": [2000, 1800, 1000], #mm, "3D_model": #Ref3DModel, "ingoing_edges": [edge1], "outgoing_edges": [edge2], "parents": ["floor", "default"], "superstructure_tags": []. For the "edge2", the attributes are "starting_node": "node5", "ending_node": "node6", "direction": "Right", "optional_tag": "normal", "distance_tag": "Proximal", "distance_value": 25, #mm, "superstructure_tag": [].

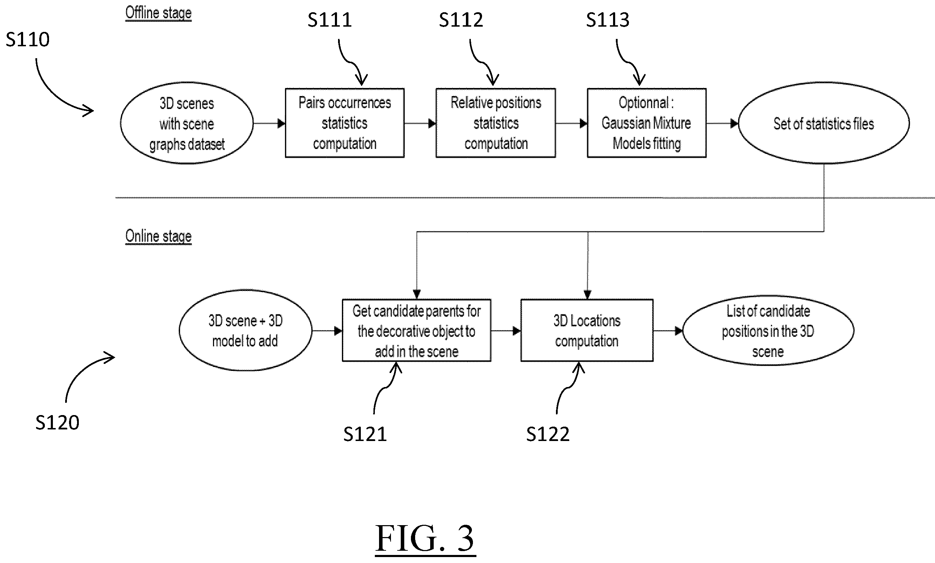

FIG. 3 shows a flowchart of an example of the offline stage S110 and the online stage 120.

The offline stage S110 concerns the computing of the dataset (statistics computation). The offline stage S110 corresponds to the computation of the various statistics files used for the positioning. All these statistics are computed based on a representative dataset of 3D scenes (each with its corresponding scene graph). The statistical analysis of the dataset allows extracting the number of occurrences of decorative-functional objects pairs and optionally of decorative-decorative objects pairs. From the number of occurrences of these pairs, the method may comprise computing the frequencies of appearance of each pair. The occurrences and frequencies of each pair are organized by categories of objects to be able to abstract the exact 3D models to their category if needed. Additionally, the method may further comprise extracting the relative locations of each pair of objects as they are seen in the dataset and saving them into a relative positions dictionary organized by objects categories and models. Optionally, the method comprises fitting Gaussian Mixture Models to the relative locations of each pair of objects and saving the parameters of these distributions for each pair in a specific file.

The online stage S120 concerns the locations computation when adding a new decorative 3D object (the input 3D object) in the 3D scene. The online stage S120 takes as input the 3D scene, the decorative 3D object to add in the 3D scene and the statistics files computed in the offline stage (the computed dataset). Based on the statistics files with the occurrences and frequencies of the pairs of objects, the method comprises selecting anchor candidates for the object to add among the 3D objects already present in the 3D scene. For each of these candidate anchors, the method computes a location based on the relative positions dictionary (or, if it exists, by sampling in the distribution of the corresponding Gaussian Mixture Model saved in the optional file). These positions are then refined (snapping it to its anchor object or filtering it if it is in conflict with other 3D objects of the 3D scene) to be valid physically and ranked. The component outputs a ranked list of locations for the 3D decorative object inside the 3D scene. The added decorative 3D object is then inserted into the 3D scene at the first location of the list or by means of a user interaction where the user selects among all outputted locations.

The offline stage S110 is now discussed in more details. All the steps detailed in this subsection may be run at time intervals or on different datasets to update the statistics files to the latest data or the most representative data at a given moment. For example, the method may regenerate these files regularly (e.g., every month) to account for updates in the 3D objects database (e.g., after an addition of new 3D objects in the previously discussed catalog).

The offline stage S110 comprises the computing S111 of pairs occurrences statistics. Based on a representative dataset of 3D indoor scenes with their corresponding scene graphs as defined above, the method comprises extracting a number of statistics on the occurrences of objects in these projects as well as the occurrences of pairs of objects.

The representative dataset may be created so as to contain only a specific type of rooms (e.g., only bedrooms or only living rooms) or a combination of several room types.

For each project, based on its scene graph, the computing S111 considers the "adjacent" and "support" edges between functional and decorative objects and optionally between two decorative objects to count the pairs of associated functional-decorative objects and optionally decorative-decorative objects. The computing S111 formalizes the pairs naming by anchor-decorative pairs where anchor may be either a functional object or optionally a decorative object. The computing S111 aggregates all the pairs occurrences on the dataset in a counts file organized by decorative categories.

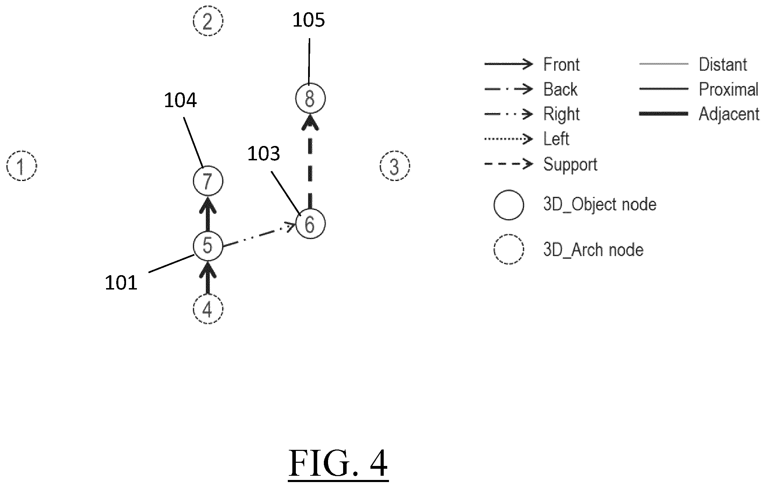

FIG. 4 illustrates examples of occurrences of pairs. In this example, object 5 101 and object 6 103 are functional and object 7 104 and object 8 105 are decorative objects. The pairs including objects 5 and 7 and objects 6 and 8 are considered pairs of associated functional-decorative objects.

The structure of the computed file is as follows:

```
     { <decorative_category> :
          { <decorative_model_ID_of_that_category> :
               { <anchor_category_associated_with_it> :
                     { "total" : total number of occurrences of pairs of that
               decorative model ID with objects of the anchor's category,
                     <anchor_model_ID_of that category> : number of
               occurrences of pairs of that decorative model ID with the anchor's
               model ID,
                     ... },
               ...},
          ...},
     ...}.
```

From this first counts file, the computing S111 comprises deriving a second file of frequencies of occurrences of pairs of anchor-decorative objects. For each pair of objects in the counts file, the computing S111 comprises deriving the count of pairs occurrences into a frequency. In details, for the "total" key, the computing S111 comprises dividing the value by the sum of all the "total" values for this decorative model ID. For the anchor keys corresponding to model IDs, the computing S111 comprises dividing the count by the value of the "total" key for this specific anchor category. Therefore, the computing S111 comprises obtaining values of frequencies between 0 and 1. The sum of all the "total" fields for a given decorative model ID is equal to 1. The sum of all the associated model IDs with it from a same anchor category is also equal to 1.

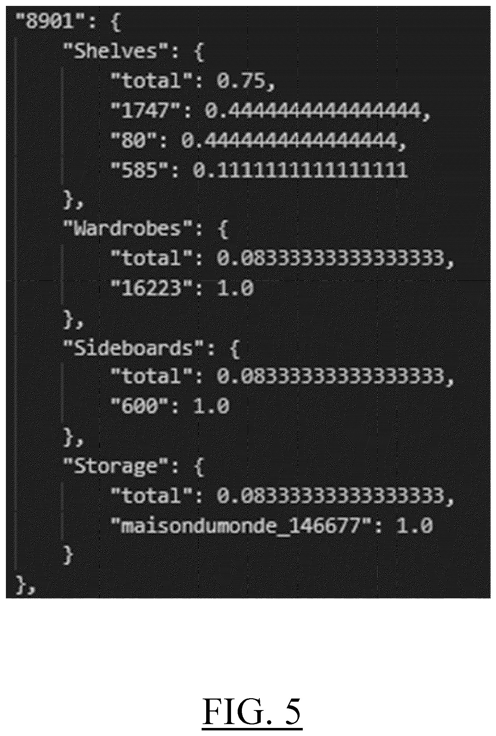

The frequency file is organized in the same way as the counts file. FIG. 5 illustrates an example of a frequency file obtained for the model ID "8901".

The idea behind this frequency file is to identify what other objects do decorative objects most often decorate in terms of both objects categories and objects models. Referring to the example of FIG. 5, the decorative object with ID "8901" is decorating shelves in 75% of its appearances in the dataset and only the models of shelves "1747", "80" and "585".

Going further than the objects categories to the objects model IDs allows to take into account geometric compatibilities. Indeed, for a certain sofa model, the method is able to identify the most geometrically compatible cushion models based on their frequency of occurrence in the dataset.

Then, the offline stage S110 comprises the computing S112 of the relative positions statistics. Based on the same representative dataset as for the pairs occurrences statistics, the computing S112 comprises extracting information on the relative positions of objects in these pairs. By relative position, the method refers to the position of the decorative object relatively to the anchor object it is decorating that is, its position in the coordinate system of that anchor object.

For each occurrence of a pair of objects counted in the previous step S111, the computing S112 comprises saving the relative position of the decorative object with respect to the anchor object as a transformation matrix. For memory space saving, this transformation matrix may be reduced to 4 values: x, y, z coordinates and an orientation value in the coordinate system of the anchor object. The computing S112 therefore obtains for each anchor-decorative pair a list of relative positions of the decorative object with respect to its anchor. These positions are all stored in a relative positions file with the following structure:

```
     { <anchor_category> :
          { <anchor_model_ID_of_that_category> :
               { "bbox" : bbox parameters of the anchor model ,
                <decorative_category_associated_with_it> :
                     { <decorative_model_ID_of that category> :
                          { "bbox" : bbox parameters of the decorative model ,
                           "rel_transfos" : list of relative positions seen in the
                     dataset stored as transformation matrices ,
                     ... },
               },
          ...},
     ...}.
```

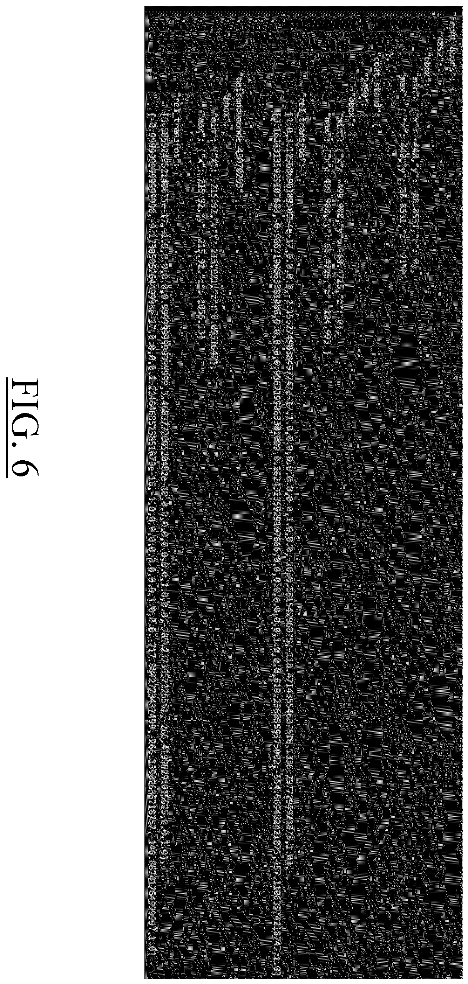

FIG. 6 illustrates an example of the determined respective positions. In this example, the determined respective positions for the model "4852" are indicated.

The fitting S113 of Gaussian Mixture Models is now discussed. This step is optional. For example, the offline stage S110 may comprise this fitting S113 step when there is enough occurrences of a pair of anchor-decorative objects. The fitting S113 may comprise fitting Gaussian Mixture Models (GMM) to the relative positioning of objects in these pairs.

This step S113 allows to fit a mix of Gaussian distributions to the relative positions of objects allowing to sample from them instead of only selecting a position seen in the relative positions file obtained from the representative dataset. Moreover, since the method may only consider the bounding boxes of the 3D objects without their exact 3D shape, fitting GMMs allows getting a better understanding of the anchors 3D models.

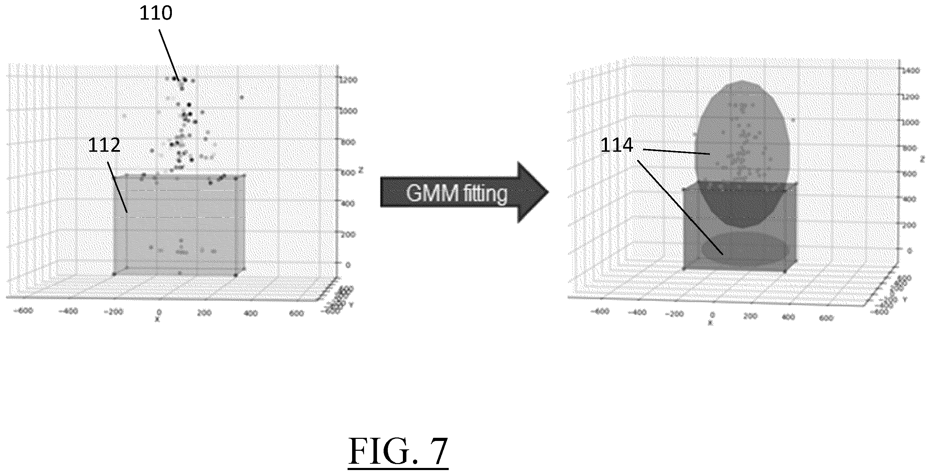

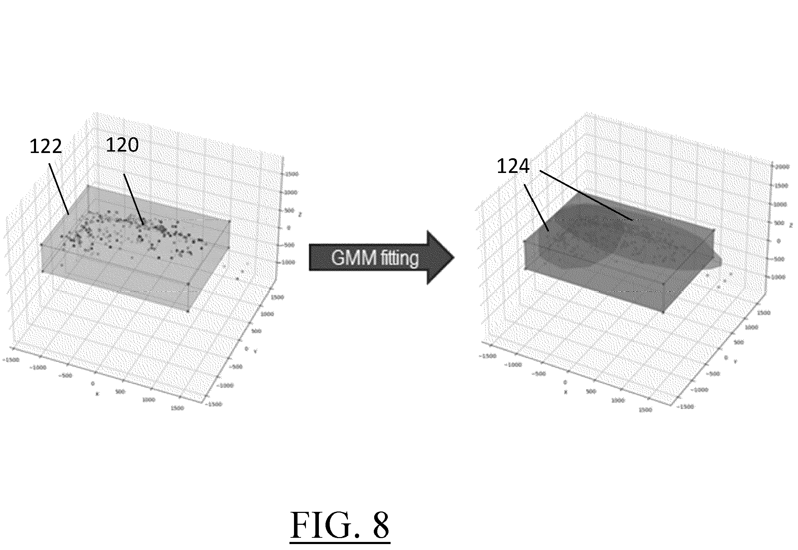

FIG. 7 illustrates a first example of fitting of the Gaussian mixture model. The figure shows lamps positions (points 110) with respect to a nightstand model (the volume 112). When fitting GMM to the positions, the method obtains two 3D Gaussian components 114 showing that the nightstand has a hole in the middle where lamps can be placed. FIG. 8 illustrates a second example of fitting of the Gaussian mixture model. The figure shows cushions positions (points 120) with respect to a sofa model (the volume 122). When fitting GMM to the positions, the method obtains two 3D Gaussian components 124 showing that the sofa has an L-shape.

In details, for each anchor-decorative objects pair with enough occurrences (in our case at least 10 occurrences), the method performs the following steps.

In a first step, the method comprises determining the number of Gaussian components that best suit our data, here the relative positions of decorative objects with respect to the anchor. To do so, the method may use the scikit-learn library's implementation of Gaussian Mixture Models fitting [8] which given a dataset and a number of Gaussian components estimates the parameters of each component, namely the weights, means and covariances of each component. The method iteratively fits GMMs to the data by iterating on the number of Gaussian components from 1 to 10. The method computes the silhouette score, e.g., also based on the scikit-learn library [8], for each of these models with a different number of components and keeps the one that has the best silhouette score (i.e., the one with the maximum silhouette score).

In a second step, the method comprises fitting a GMM to it with the previously determined number of components. The method may keep only the components that have a weight > 0.05 (5%) to avoid components formed by outliers in the dataset. The method may save the parameters of each component (weight, mean and covariance) in lists.

This process is also performed on the aggregation of all decorative objects of the same category for a given anchor to gather information on the anchor even when it has been decorated by various decorative objects of the same category (while each decorative object considered separately might represent only few occurrences). The method may save the GMMs parameters in another file organized in the same way as the previously computed statistics files.

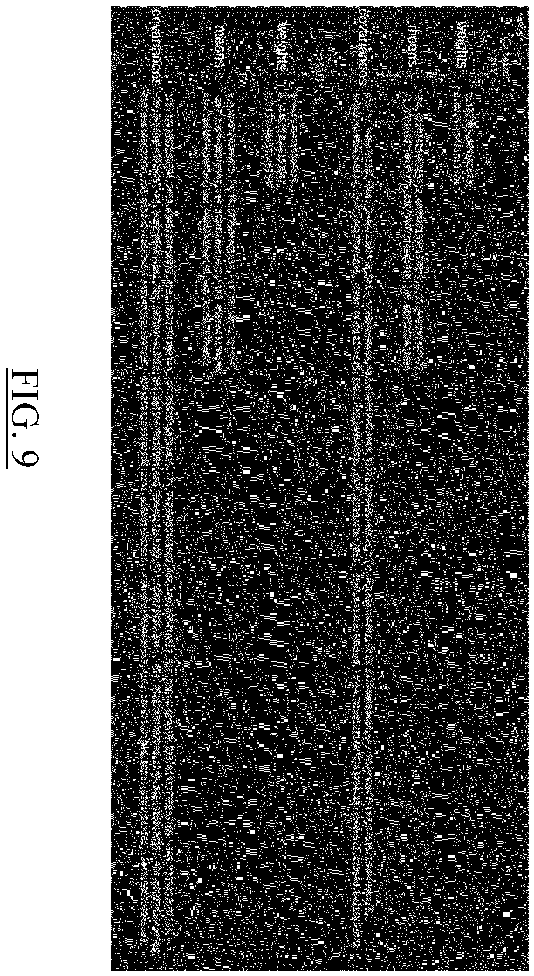

FIG. 9 illustrates a sample example for the model "4975". The GMM for the positions of "all" curtains decorating "4975" has two components while the GMM for the "15915" curtains has three components.

The online stage S120 is now discussed in more details.

The online stage S120 comprises determining S121 of the candidate anchors. Given a 3D scene partially furnished with 3D objects, a 3D decorative object to add to the scene and the frequency file computed on a representative dataset, the method seeks to identify potential anchors (i.e., functional objects to decorate) for the inserted 3D decorative object. The model ID of the decorative object to add is denoted by *deco_ID* and by *deco_cat* its category.

The determining S121 of the candidate anchors comprises executing computer program instructions that cause attempting to identify the pairs. In details, the computer program instructions may comprise instructions for perform the following steps to create a list of candidate anchors:
- Initializing an empty list of candidate anchors;
- Checking if *deco_ID* is in the primary keys of the frequency file. If not, this means that the object was not present in the dataset used for its generation. This can happen when adding an object that was added in the database of the 3D object after the computation of the frequency files. If the model is unknown, *deco_ID* takes the value of the model ID of the closest object in size from the *deco_cat* category.
- For each 3D object present in the scene:
   ∘ Considering *obj_ID* the model ID of the 3D object and *obj_cat* its category;
   ∘ If the pair *obj_ID-deco_ID* exists in the frequency file, then, adding the 3D object in the list of candidate anchors.
   ∘ Else if the pair does not appear in the frequency file but there are pairs with *obj_ID* and other decorative objects of the *deco_cat* category, selecting among these pairs the one with the decorative object closest in size from the one to add in the scene. The decorative model ID of this pair is denoted by *closest_deco_ID.* Then, adding the 3D object in the list of candidate anchors with the closest pair information.
   ∘ Else if the pair does not appear in the frequency file, determining the closest object in size from the 3D object among *obj_cat* objects and denoting its model ID by *closest_obj_ID.*
      ▪ If the pair *closest_obj_ID-deco_ID* exists in the frequency file, then, adding the 3D object in the list of candidate anchors with the closest pair information.
      ▪ Else if the pair does not exist but there are pairs with *closest_obj_ID* and other decorative objects of the *deco_cat* category, selecting among these pairs the one with the decorative object closest in size from the one to add in the scene. The decorative model ID of this pair is denoted by *closest_deco_ID.* Then, adding the 3D object in the list of candidate anchors with the closest pair information.
      ▪ Else, considering that the considered 3D object cannot be an anchor, and moving to the next 3D object in the 3D scene.

The executing of the computer program instructions thus obtains a list of candidate anchors for the 3D decorative object to add in the 3D scene. Each element of the candidate anchors list refers to an object already in the 3D scene and is itself a list containing:
- *idx:* the index of the 3D object in the 3D scene;
- *freq:* the frequency taken from the frequency file for the pair used to add the 3D object in the candidates list (according to the step in which it was added);
- *ref_deco_model:* the *closest_deco_ID* if used, "None" otherwise;
- *ref_anchor_model:* the *closest_obj_ID* if used, "None" otherwise.

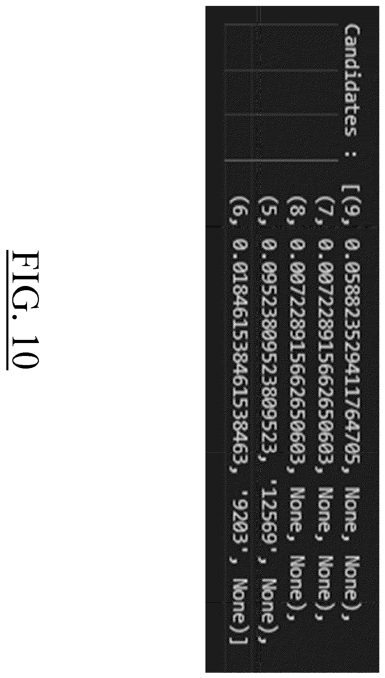

After the identifying of the pairs, the determining S121 of the candidate anchors comprises the outputting of the pairs among the identified pairs. The outputting may be based on a ranking according to the counts of the identified pairs. For example, the method may comprise ranking the obtained anchors candidates list, first by their frequencies (i.e., the second values of the sublists) from the highest to the lowest. Then, the method may rank it again in order to have first the candidate anchors which appeared as a pair in the frequency file with the original decorative model ID to add to the 3D scene, that is, the candidate anchors for which *ref_deco_model* is "None". FIG. 10 illustrates an example of a ranked list of candidate anchors obtained by the method using these computer program instructions.

If no 3D object of the 3D scene is added to the list of candidate anchors, the decorative object is inserted in a default location in the 3D scene (e.g., the center of the room or a free space in the room visible on the user's screen).

Once the list of candidate anchors is obtained, the online stage S120 comprises computing S122 locations for the outputted pairs (i.e., determining, for each outputted pair, a respective position of the input 3D object in the input 3D scene). The computing S122 of the locations comprises computing a 3D position for the decorative object to insert for each of the candidate anchors of the obtained list.

In details, for each candidate anchor in the previously computed list, the method may execute computer program instructions for performing:
i. If *ref_deco_model* is "None" (i.e., the *deco_ID* for the selected pair is the original model ID of the decorative model to add in the 3D scene):
   a. If *ref_anchor_model* is "None" (i.e. the selected pair is *obj_ID-deco_ID*): randomly selecting a relative position from the "rel_transfos" list of the pair *obj_ID-deco_ID* in the relative positions file. Then, applying it to the inserted decorative object with respect to the anchor candidate to obtain the absolute position of the inserted decorative object (as a transformation matrix).
   b. Else, when *ref_anchor_model* is not "None" (i.e. the selected pair is *ref_anchor_model-deco_ID*): randomly selecting a relative position from the "rel_transfos" list of the pair *ref_anchor_mode*/*-deco_ID* in the relative positions file. Then, applying it to the inserted decorative object with respect to the anchor candidate to obtain the absolute position of the inserted decorative object (as a transformation matrix).
ii. Else, when *ref_deco_model* is not "None" (i.e. the selected pair does not contain the original model ID *deco_ID* of the decorative model to add in the 3D scene but the closest one in size from the same category):
   a. If *ref_anchor_model* is "None" (i.e. the selected pair is *obj_ID-ref_deco_model*): randomly selecting a relative position from the "rel_transfos" list of the pair *obj_ID-ref_deco_model* in the relative positions file. Then, applying it to the inserted decorative object with respect to the anchor candidate to obtain the absolute position of the inserted decorative object (as a transformation matrix).
   b. Else, when *ref_anchor_model* is not "None" (i.e. the selected pair is *ref_anchor_model-ref_deco_model*): randomly selecting a relative position from the "rel_transfos" list of the pair *ref_anchor_model-ref_ deco_model* in the relative positions file. Then, applying it to the inserted decorative object with respect to the anchor candidate to obtain the absolute position of the inserted decorative object (as a transformation matrix).

Alternatively, instead of directly selecting a 3D position from the relative positions file, the method may sample a 3D location using the GMM parameters in the GMM parameters file if they have been computed in the offline stage. Alternatively, the method may sample a 3D location in each Gaussian component of the GMM. Alternatively, the method may select the position from the relative positions file closest to the center of the GMM component instead of directly sampling from it. These different alternatives lead to different behaviors and different levels of 3D positioning variety.

The verifying of the absence of intersection is now discussed (conflicts management). Once the absolute 3D position of the decorative object to insert is obtained, the method may comprise verifying that it does not collide with other objects in the 3D scene. Since the method may consider only the bounding boxes of the 3D objects, the method may not consider collisions with the anchor of the inserted object. Indeed, some collisions, in the bounding box sense, might not be problematic (e.g., cushions on sofas will have their bounding box included in the sofa's bounding box but are valid locations).

In details, for each object of the 3D scene excluding the anchor of the inserted object, the method may comprise computing the volume of the intersection of its bounding box with the inserted object's bounding box. The method may also comprise computing the volume of their union. Then, the method may comprise using the Intersection over Union (IoU) ratio to determine if the collision has to be considered as a conflict. If the loU ratio is greater than a threshold (0.05 in our implementation), the method may comprise considering that the collision is a conflict and may comprise ignoring this solution.

Alternatively, in case of conflict, the method may comprise selecting another position from the "rel_transfos" list of the corresponding pair depending on which case (i.a., i.b., ii.a. or ii.b.) the insertion takes place. Or alternatively, if the method has computed GMM parameters in the offline stage, the method may comprise sampling a new position from another component for example.

The snapping is now discussed in more details. In the cases i.b., ii.a. and ii.b. where the method uses other objects than the ones in the 3D scene or the 3D object to add, i.e. *ref_anchor_model* or *ref_deco_model* or both, lead to the computation of imperfect 3D positions for the object to insert with respect to its anchor. In practice, the inserted object may float over or be in collision with its anchor. To re-align the inserted object, the method may use a "snapping" function to refine and correct its 3D position.

The snapping function takes as input the inserted object, an origin point on the bounding box of this object and a direction in which to look for a surface on which to snap the inserted object.

The method may distinguish three cases for snapping:
- When the inserted object is a ceiling lamp, the method may snap it to the ceiling: the top of the ceiling lamp's bounding box may be placed against the ceiling's surface modifying accordingly the z coordinate of the ceiling lamp. In this case, the origin point is the center of the top side of the bounding box of the ceiling lamp and the direction is upwards (towards the ceiling).
- When the inserted object is a mural object (e.g. wall lamps, frames, wall mirrors), the method may snap this object to the closest wall: the back of the mural object may be placed against the wall's surface modifying the *x* and *y* axis of the mural object. In this case, the origin point is the center of the back side of the bounding box of the mural object and the direction is the normal of this side of the bounding box. The first wall surface found in this direction may be the one to which the object will be snapped.
- In all other cases, the method may snap the inserted object to the closest horizontal surface to account for gravity, modifying only the *z* coordinate of the inserted object. In this case, the origin point is the center of the bottom side of the bounding box of the inserted object and, the method may consider two directions. One direction is downwards (towards the floor) and the other is upwards (towards the ceiling). The method may collect for each direction the closest horizontal surface and finally perform the snapping to the surface which is the closest between these 2 directions.

This also allows 3D position corrections for the inserted object in the case where the dataset used for the computation of the statistics files in the offline stage is not of a good enough quality (users can misplace objects in their projects).

The last two steps ensure that the computed 3D positions of the inserted decorative objects are valid physically (no collisions and no floating objects).

With reference to FIG.s 11 to 22, examples of positioning of input 3D objects are now discussed.

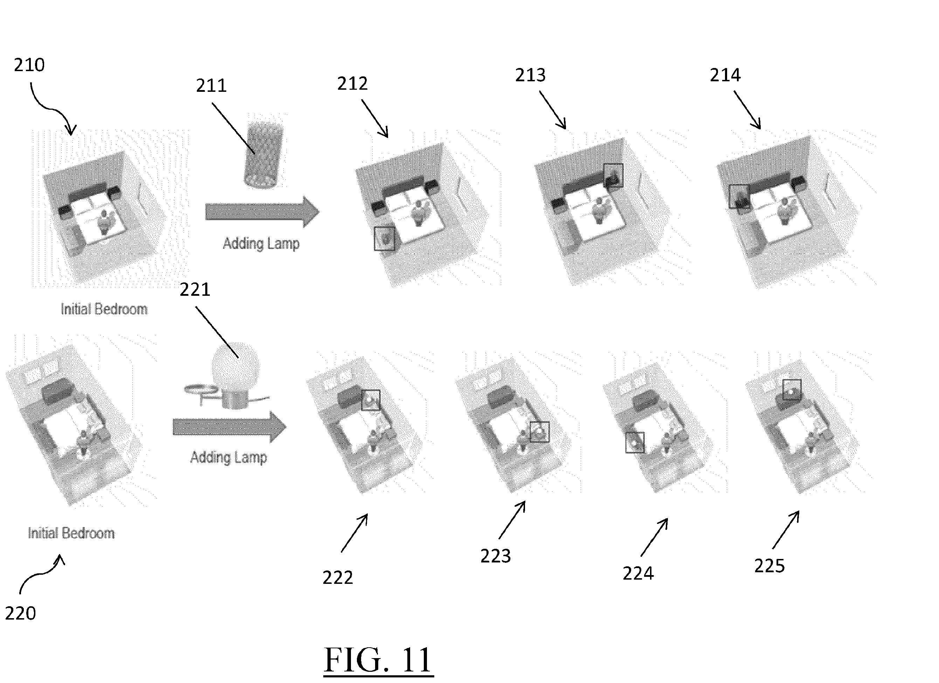

In each of the FIG.s 11 to 18, two different objects belonging to a same category are positioned by the method in two different bedrooms. For example, FIG. 11 illustrates the first bedroom 210 wherein a first lamp 211 is positioned by the method, and the second bedroom 220 wherein a second lamp 221 is positioned by the method. For each bedroom, the figure shows the different relative positions computed by the method. For the first lamp 211 in the first bedrooms 210, the method provides three respective positions 212, 213 and 214 (each corresponding to a respective outputted pairs). The user may therefore select whether to position the lamp between the three respective positions 212, 213, 214. For the second lamp 221 in the second bedroom 210, the method provides four respective positions 222, 223, 224 and 225 (the pairs outputted by the method including an additional pair due to the presence of an additional table in the second bedroom 210). The user may therefore select whether to position the lamp between the four determined respective positions 222, 223, 224 and 225.

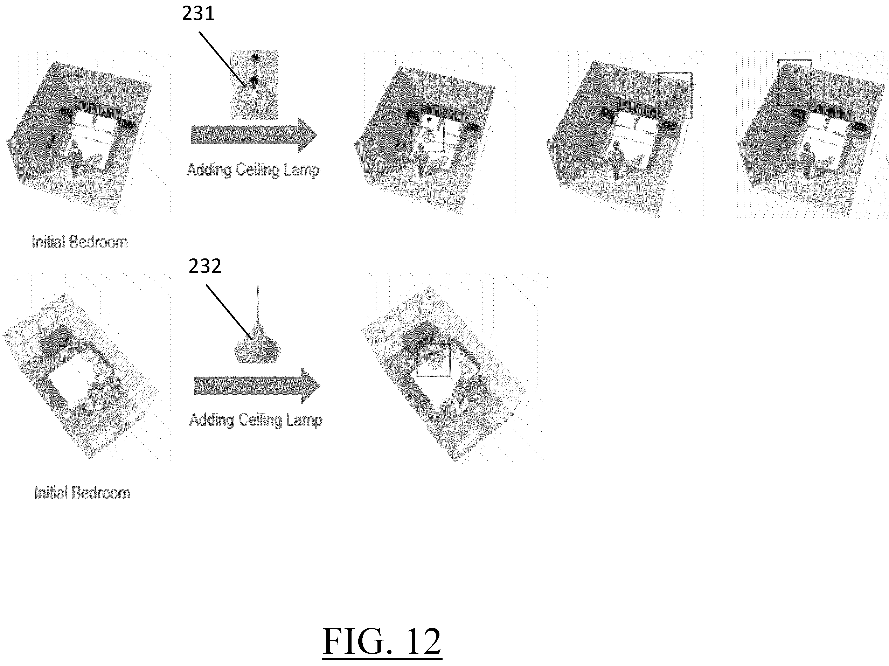

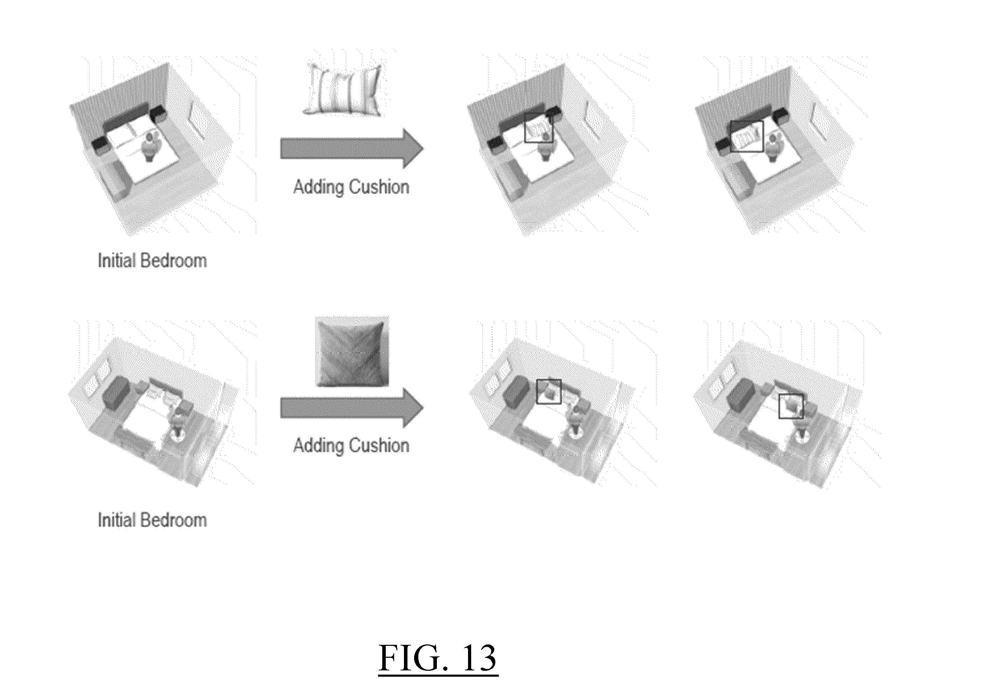

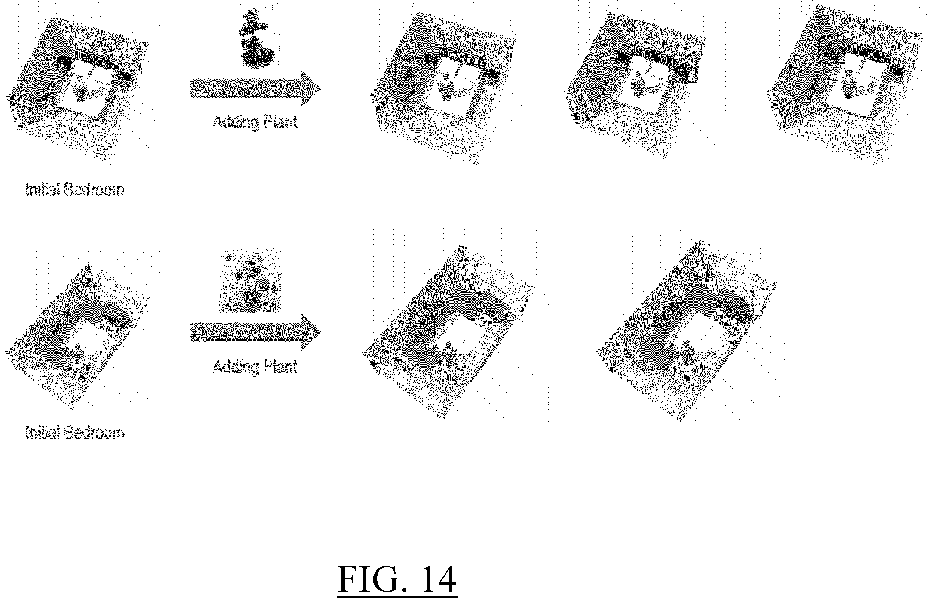

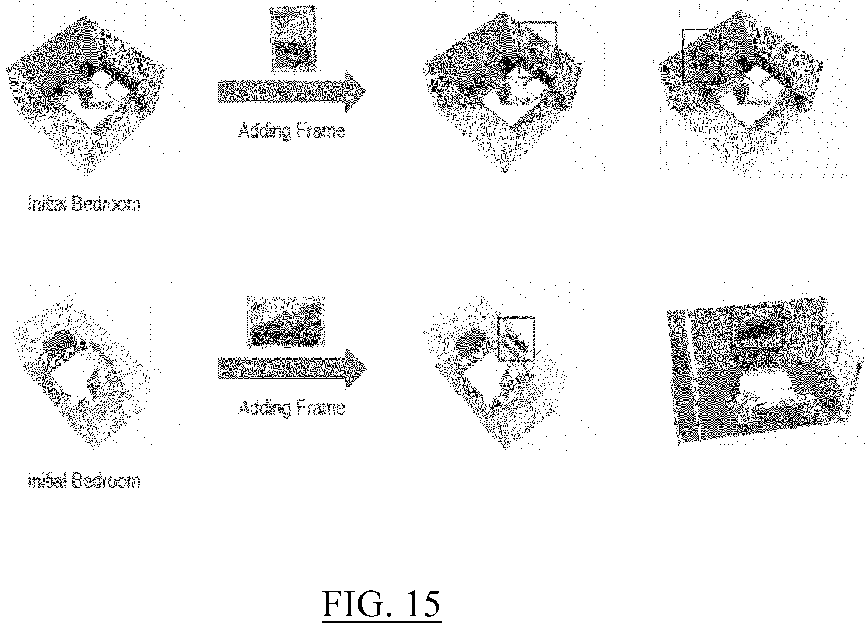

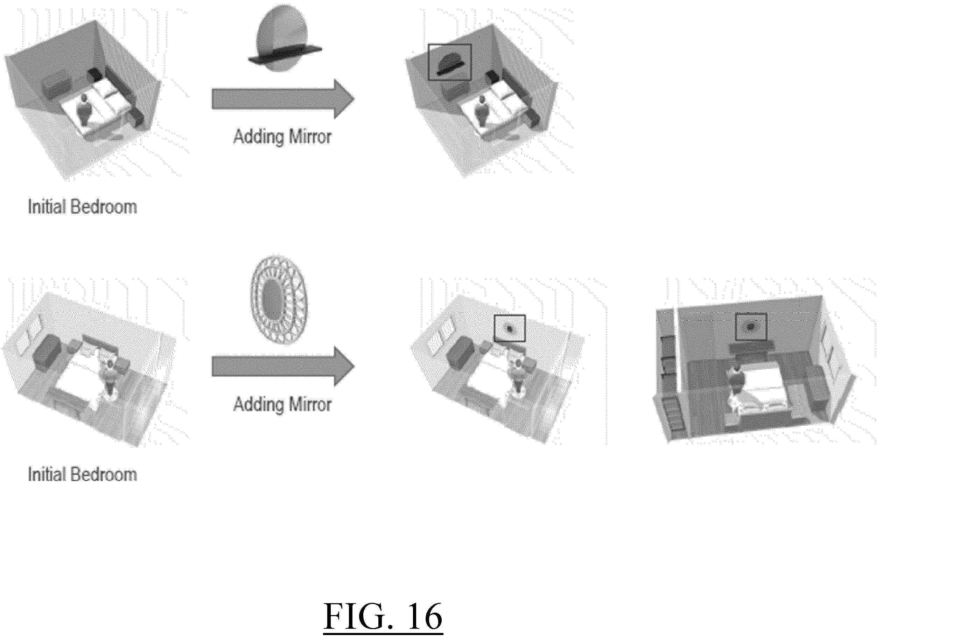

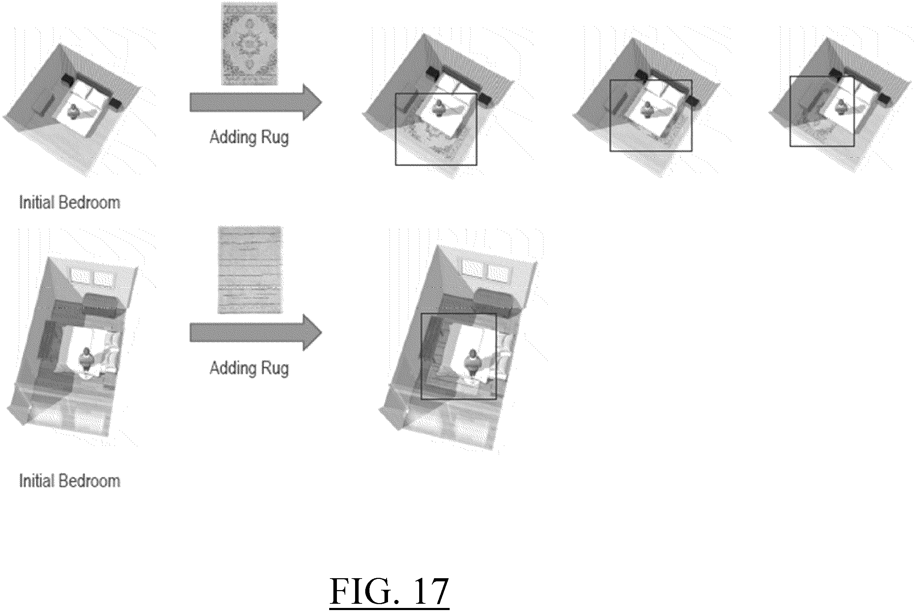

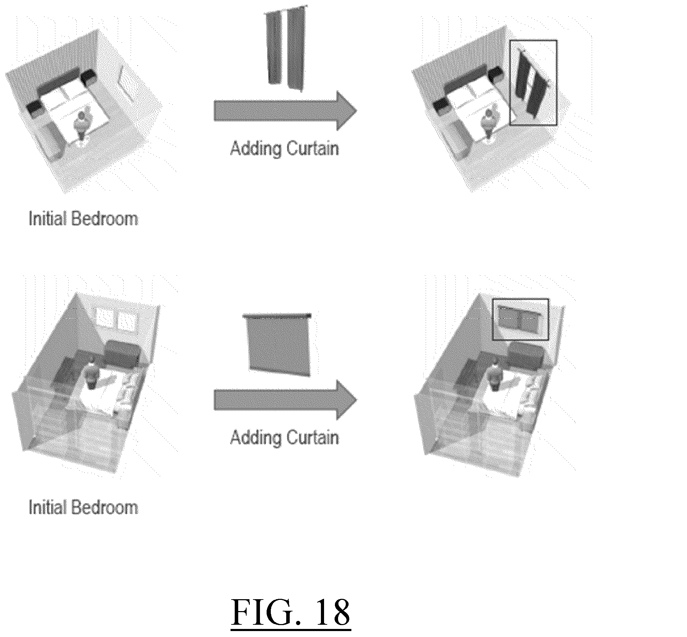

FIG. 12 illustrates examples of positioning for the vertical superposition relationship. In these examples, the method identifies that the dataset comprises occurrences of pairs including the lamps 231 and 241 (added in the bedrooms) arranged according to a vertical superposition relationship with other 3D objects of the bedroom (the bed or bedroom tables). The method therefore computes positions for the lamps 231 and 241 above these objects.

Similarly, FIG.s 13 to 18 illustrate the positions computed by the method for the same bedrooms previously discussed when the input 3D objects are respectively cushions, plants, frames, mirrors, rugs or curtains.

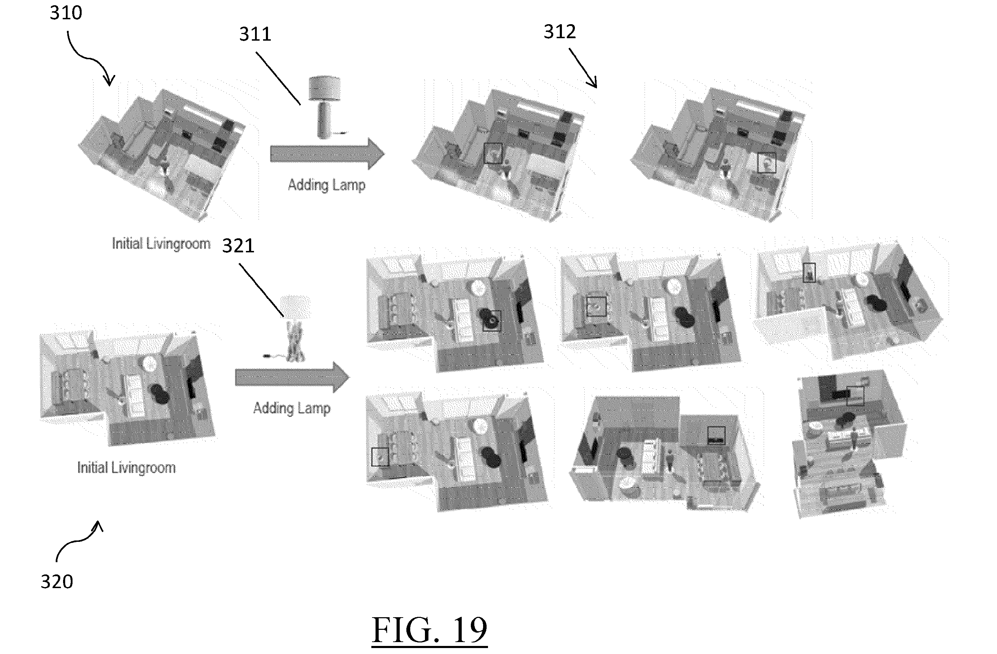

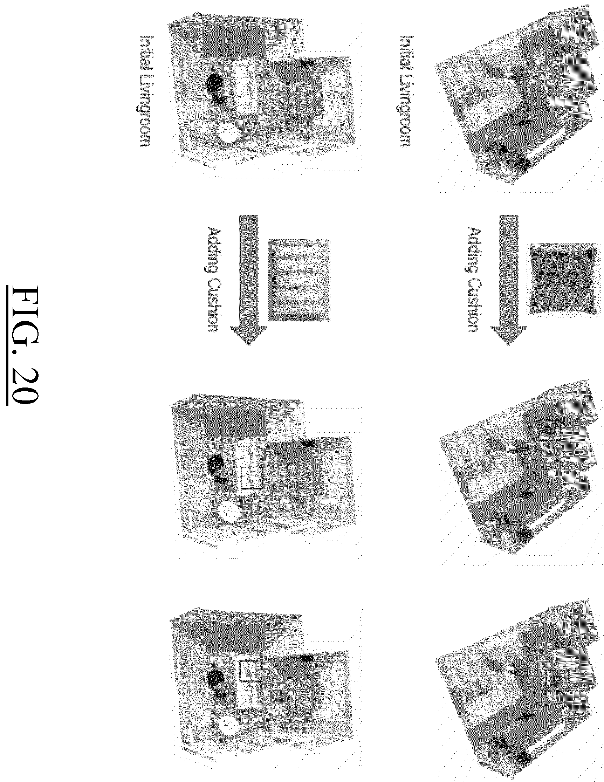

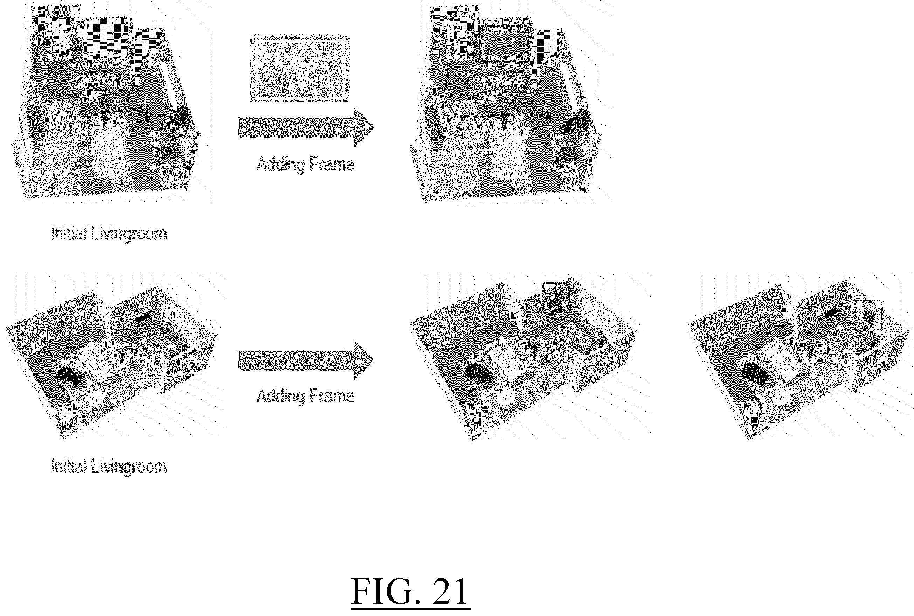

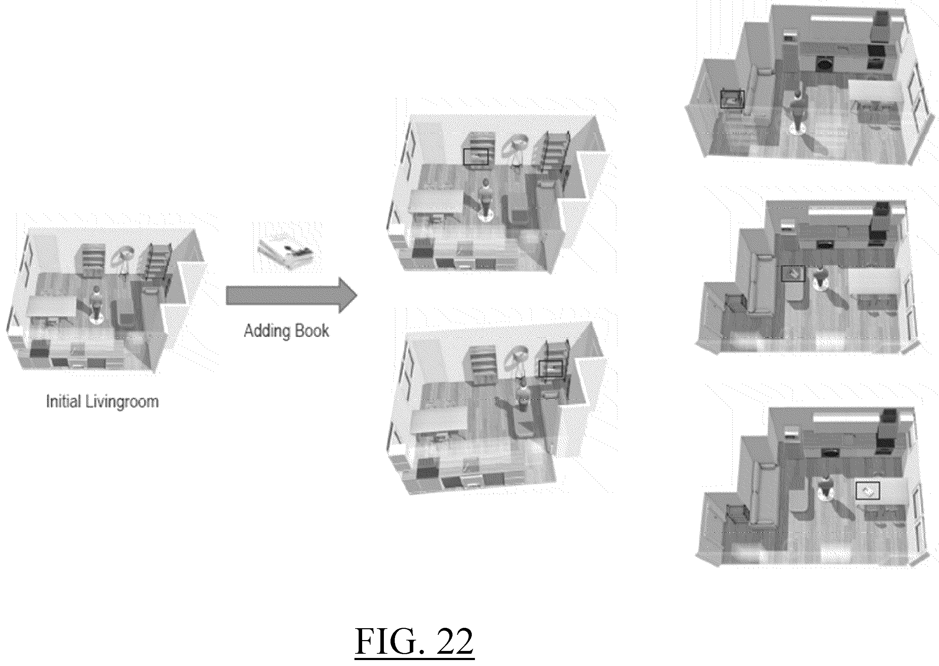

In FIG.s 19 to 21, two different objects are this time positioned by the method in two different livingrooms. For example, FIG. 19 illustrates the first livingroom 310 wherein a first lamp 311 is added, and the second livingroom 320 wherein a second lamp 321 is added. For each livingroom, the figure shows the different relative positions 312 computed by the method. The user may therefore select whether to position the lamp between these different relative positions 312. Similarly, FIG.s 20 and 21 illustrate the positions computed by the method for the same livingrooms when the input 3D objects are respectively cushions or frames.

FIG.s 22 illustrates the positions computed by the method for a livingroom comprising different shelves and when the input 3D objects is a book. In that case, the method allows computing positions on different shelf levels.

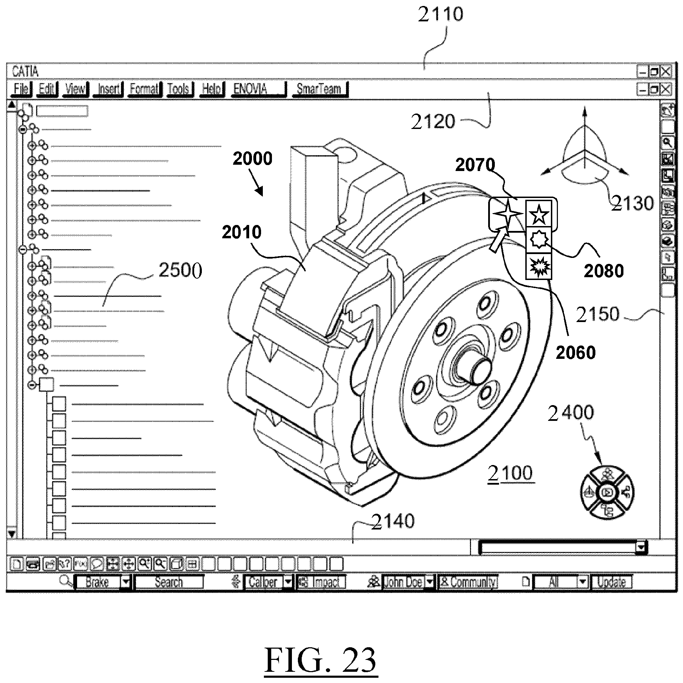

FIG. 23 shows an example of the GUI of the system, wherein the system is a CAD system.

The GUI 2100 may be a typical CAD-like interface, having standard menu bars 2110, 2120, as well as bottom and side toolbars 2140, 2150. Such menu- and toolbars contain a set of user-selectable icons, each icon being associated with one or more operations or functions, as known in the art. Some of these icons are associated with software tools, adapted for editing and/or working on the 3D modeled object 2000 displayed in the GUI 2100. The software tools may be grouped into workbenches. Each workbench comprises a subset of software tools. In particular, one of the workbenches is an edition workbench, suitable for editing geometrical features of the modeled product 2000. In operation, a designer may for example pre-select a part of the object 2000 and then initiate an operation (e.g. change the dimension, color, etc.) or edit geometrical constraints by selecting an appropriate icon. For example, typical CAD operations are the modeling of the punching or the folding of the 3D modeled object displayed on the screen. The GUI may for example display data 2500 related to the displayed product 2000. In the example of the figure, the data 2500, displayed as a "feature tree", and their 3D representation 2000 pertain to a brake assembly including brake caliper and disc. The GUI may further show various types of graphic tools 2130, 2070, 2080 for example for facilitating 3D orientation of the object, for triggering a simulation of an operation of an edited product or render various attributes of the displayed product 2000. A cursor 2060 may be controlled by a haptic device to allow the user to interact with the graphic tools.

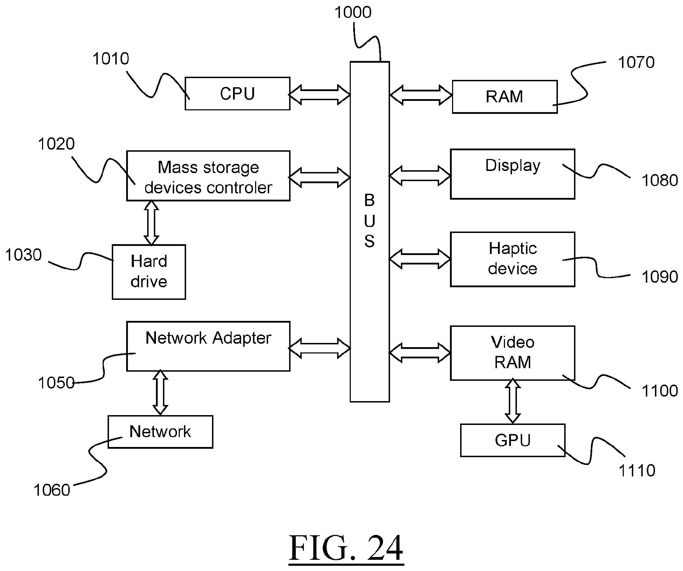

FIG. 24 shws an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

## Claims

1. A computer-implemented method for automatically positioning an input 3D object representing a real object in an input 3D scene representing a room, the input 3D scene including a plurality of positioned 3D objects, the plurality of positioned 3D objects including positioned furniture 3D objects each representing a real piece of furniture, the method comprising:
• obtaining (S10) a dataset comprising information about objects of a plurality of rooms, the information including:
∘ a classification of the objects of the plurality of rooms,
∘ counts each of the set consisting of each occurrence of a respective pair including a same first real object and a same second real object in a room, wherein the first real object and the second real object of each occurrence of each respective pair are arranged according to a mutual arrangement relationship from a predetermined set of one or more mutual arrangement relationships, and
∘ information regarding the relative positioning of the first real object and the second real object in each occurrence of each pair;
• executing (S20) computer program instructions that cause:
∘ attempting to identify in the dataset one or more first pairs each including the input 3D object and a respective positioned 3D object of the input 3D scene;
∘ when no first pair is identified, attempting to identify in the dataset one or more second pairs each including only one of the input 3D object and a respective positioned 3D object of the input 3D scene, and an equivalent object for the other one, a given real object being an equivalent object for another given real object when the given real object has the same classification than the another given real object and the given real object is, among the set consisting of each real object of the same classification present in the dataset, the closest in size to the another given real object;
∘ when no first pair is identified and no second pair is identified, attempting to identify in the dataset one or more third pairs each including an equivalent object for the input 3D object and an equivalent object for a respective positioned 3D object of the input 3D scene;
• outputting (S30) one or more pairs among the set consisting of each identified pair and the counts of the one or more identified pairs, the outputting being based on the set consisting of each count for a respective identified pair of the set consisting of each identified pair;
• for each outputted pair, determining (S40) a respective position of the input 3D object in the input 3D scene based on the information regarding the relative positioning of the first real object and the second real object in each occurrence of the outputted pair, wherein, for each outputted pair, the respective position of the input 3D object in the input 3D scene determined for the outputted pair has no conflict with any other 3D object of the plurality of positioned 3D objects of the input 3D scene, wherein the determination of the conflict comprises:
∘ verifying that an intersection between the input 3D object and all other 3D objects in the input scene is zero, or
∘ each 3D object of the scene being represented by a 3D bounding box, computing the volume of the intersection of its bounding box with the input 3D object's bounding box and if it is determined that the volume of the intersection is above a certain threshold, then, considering that the collision is a conflict and ignoring this solution
, wherein the determining (S40) of the respective position for each outputted pair comprises:
∘ relatively positioning (S41) the input 3D object with the other object of the pair in the input 3D scene based on the information regarding the relative positioning of the first real object and the second real object in each occurrence of the outputted pair;
∘ snapping (S42) the relatively positioned input 3D object on an element of the 3D scene, wherein the snapping comprises automatically sticking the input 3D object on the element of the 3D scene while staying within the relatively positioning determined in the previous step (S41), wherein the snapping further comprises determining the element of the 3D scene on which the input 3D object is snapped, and then snapping the input 3D object on this determined element, wherein the determined element depends on the category of the input 3D object and is the closest to the positioned input 3D object, and, depending on the determined category of the input 3D object, the snapping comprises snapping the input 3D object on the ceiling or on the closest wall or on the closest horizontal surface to account for gravity, thereby modifying only the z coordinate of the input 3D object;
• positioning (S50) the input 3D object according to the respective position determined for one of the one or more outputted pairs;
• evaluating one or more layout metrics on the room represented by the input scene, wherein the one or more layout metrics include a circulation metric, a brightness metric, an accessibility metric and/or an ergonomics metric;
wherein the real-life room design process is repeated for multiple input objects using said evaluated layout metrics, positioning different input objects inside the input 3D scene, to ensure ease of movement, accessibility of certain objects, safety or a certain level of ergonomics in the room, and the method further comprises building the room according to the 3D scene with the positioned input 3D objects.

2. The method of claim 1, wherein the predetermined set of one or more mutual arrangement relationships comprises an adjacency relationship and/or a vertical superposition relationship.

3. The method of claim 1 or 2, wherein the pairs of the dataset comprise pairs including a decorative object and a furniture object.

4. The method of any one of claims 1 to 3, wherein the pairs of the dataset comprise pairs including a decorative object and another decorative object.

5. The method of claim 1, wherein, for each outputted pair, the information regarding the relative positioning of the first real object and the second real object in each occurrence of the outputted pair comprises a respective relative positioning for each occurrence, the method further comprising, prior to the relatively positioning (S41) for each outputted pair, fitting parameters of a Gaussian mixture model to the relative positioning of objects in the occurrences of the pair, the relatively positioning (S41) comprising sampling in the distribution represented by the Gaussian mixture model for the fitted parameters.

6. The method of any one of claims 1 to 5, wherein each outputted pair has a count higher than a predetermined number.

7. The method of any one of claims 1 to 6, wherein each room of the dataset is of the same type as the room represented by the input 3D scene.

8. The method of any one of claims 1 to 7, wherein the one or more outputted pairs comprise several outputted pairs, the method further comprising, prior to the positioning, user-selecting the one of the one or more outputted pairs from which the input 3D object is positioned.

9. The method of any one of claims 1 to 7, wherein the one or more outputted pairs comprise several outputted pairs, the method further comprising, prior to positioning, ranking the outputted pairs according to the count of the outputted pairs in the dataset, the outputted pair from which the input 3D object is positioned being the one having the highest ranking.

10. The method of any one of claims 1 to 9, the method further comprises, after the positioning (S50) of the input 3D object, displaying (S60) the positioned input 3D object.

11. A computer program comprising instructions for performing the method of any of claims 1-10.

12. A computer readable storage medium having recorded thereon a computer program of claim 11.

13. A system comprising a processor coupled to a memory, the memory having recorded thereon the computer program of claim 11.

## Patentansprüche

1. Computergestütztes Verfahren zum automatischen Positionieren eines Eingabe-3D-Objekts, das ein reales Objekt repräsentiert, in einer Eingabe-3D-Szene, die einen Raum repräsentiert, wobei die Eingabe-3D-Szene eine Vielzahl von positionierten 3D-Objekten umfasst, wobei die Vielzahl von positionierten 3D-Objekten positionierte Möbel-3D-Objekte umfasst, die jeweils ein reales Möbelstück repräsentieren, das Verfahren umfassend:
• Erlangen (S10) eines Datensatzes, umfassend Informationen über Objekte einer Vielzahl von Räumen, wobei die Informationen Folgendes beinhalten:
∘ eine Klassifizierung der Objekte der Vielzahl von Räumen,
∘ Zählungen von jedem des Satzes, bestehend aus jedem Vorkommen eines jeweiligen Paars, das ein gleiches erstes reales Objekt und ein gleiches zweites reales Objekt in einem Raum beinhaltet, wobei das erste reale Objekt und das zweite reale Objekt von jedem Vorkommens jedes jeweiligen Paars gemäß einer gegenseitigen Anordnungsbeziehung aus einem vorbestimmten Satz von einer oder mehreren gegenseitigen Anordnungsbeziehungen angeordnet sind, und
∘ Informationen bezüglich der relativen Positionierung des ersten realen Objekts und des zweiten realen Objekts in jedem Vorkommen jedes Paars;
• Ausführen (S20) von Computerprogrammanweisungen, die Folgendes bewirken:
∘ Versuchen, in dem Datensatz ein oder mehrere erste Paare zu identifizieren, die jeweils das Eingabe-3D-Objekt und ein jeweiliges positioniertes 3D-Objekt der Eingabe-3D-Szene umfassen;
∘ wenn kein erstes Paar identifiziert wird, Versuchen, in dem Datensatz ein oder mehrere zweite Paare zu identifizieren, die jeweils nur eines von dem Eingabe-3D-Objekt und einem jeweiligen positionierten 3D-Objekt der Eingabe-3D-Szene und einem äquivalenten Objekt für das jeweils andere beinhalten, wobei ein gegebenes reales Objekt ein äquivalentes Objekt für ein anderes gegebenes reales Objekt ist, wenn das gegebene reale Objekt die gleiche Klassifizierung wie das andere gegebene reale Objekt aufweist und das gegebene reale Objekt unter den aus bestehenden realen Objekten der gleichen Klassifizierung, die in dem Datensatz vorhanden sind, jenes ist, das dem anderen gegebenen realen Objekt in der Größe am nächsten kommt;
∘ wenn kein erstes Paar identifiziert wird und kein zweites Paar identifiziert wird, Versuchen, in dem Datensatz ein oder mehrere dritte Paare zu identifizieren, die jeweils ein äquivalentes Objekt für das Eingabe-3D-Objekt und ein äquivalentes Objekt für ein jeweiliges positioniertes 3D-Objekt der Eingabe-3D-Szene beinhalten;
• Ausgeben (S30) eines oder mehrerer Paare aus dem Satz, der aus jedem identifizierten Paar und den Zählungen des einen oder der mehreren identifizierten Paare besteht, wobei das Ausgeben auf dem Satz basiert, der aus jeder Zählung für ein jeweiliges identifiziertes Paar des Satzes besteht, der aus jedem identifizierten Paar besteht;
• für jedes ausgegebene Paar, Bestimmen (S40) einer jeweiligen Position des Eingabe-3D-Objekts in der Eingabe-3D-Szene basierend auf den Informationen bezüglich der relativen Positionierung des ersten realen Objekts und des zweiten realen Objekts in jedem Vorkommen des ausgegebenen Paars, wobei für jedes ausgegebene Paar die jeweilige Position des Eingabe-3D-Objekts in der Eingabe-3D-Szene, die für das ausgegebene Paar bestimmt wird, keinen Konflikt mit einem anderen 3D-Objekt der Vielzahl von positionierten 3D-Objekten der Eingabe-3D-Szene aufweist, wobei die Bestimmung des Konflikts Folgendes umfasst:
∘ Überprüfen, dass eine Schnittfläche zwischen dem Eingabe-3D-Objekt und allen anderen 3D-Objekten in der Eingabeszene null ist, oder
∘ für jedes 3D-Objekt der Szene, das durch eine 3D-Begrenzungsbox dargestellt ist, Berechnen des Volumens der Schnittfläche seiner Begrenzungsbox mit der Begrenzungsbox des Eingabe-3D-Objekts und wenn bestimmt wird, dass das Volumen der Schnittfläche über einem bestimmten Schwellenwert ist, Annehmen, dass die Kollision ein Konflikt ist und Ignorieren dieser Lösung, wobei das Bestimmen (S40) der jeweiligen Position für jedes ausgegebene Paar Folgendes umfasst:
∘ relatives Positionieren (S41) des Eingabe-3D-Objekts mit dem anderen Objekt des Paars in der Eingabe-3D-Szene basierend auf den Informationen bezüglich der relativen Positionierung des ersten realen Objekts und des zweiten realen Objekts in jedem Vorkommen des ausgegebenen Paars;
∘ Snappen (S42) des relativ positionierten Eingabe-3D-Objekts auf ein Element der 3D-Szene, wobei das Snappen das automatische Anheften des Eingabe-3D-Objekts an das Element der 3D-Szene umfasst, während die in dem vorherigen Schritt (S41) bestimmte relative Positionierung beibehalten wird, wobei das Snappen ferner ein Bestimmen des Elements der 3D-Szene umfasst, auf das das Eingabe-3D-Objekt gesnappt wird, und anschließend das Snappen des Eingabe-3D-Objekts auf dieses bestimmte Element, wobei das bestimmte Element von der Kategorie des Eingabe-3D-Objekts abhängt und das dem positionierten Eingabe-3D-Objekt am nächsten gelegene ist, und je nach bestimmter Kategorie des Eingabe-3D-Objekts das Snappen ein Snappen des Eingabe-3D-Objekts an die Decke oder an die nächstgelegene Wand oder an die nächstgelegene horizontale Fläche umfasst, um der Schwerkraft Rechnung zu tragen, wobei nur die z-Koordinate des Eingabe-3D-Objekts geändert wird;
• Positionieren (S50) des Eingabe-3D-Objekts gemäß der jeweiligen für eines der einen oder mehreren ausgegebenen Paare bestimmten Position;
• Bewerten eines oder mehrerer Layout-Metriken für den durch die Eingabeszene dargestellten Raum, wobei die eine oder mehreren Layout-Metriken eine Zirkulationsmetrik, eine Helligkeitsmetrik, eine Zugänglichkeitsmetrik und/oder eine Ergonomiemetrik beinhalten;
wobei der reale Raumgestaltungsprozess für mehrere Eingabeobjekte unter Verwendung der bewerteten Layout-Metriken wiederholt wird, wobei verschiedene Eingabeobjekte innerhalb der Eingabe-3D-Szene positioniert werden, um Bewegungsfreiheit, Zugänglichkeit bestimmter Objekte, Sicherheit oder ein bestimmtes Maß an Ergonomie im Raum zu gewährleisten, und das Verfahren ferner ein Bauen des Raums gemäß der 3D-Szene mit den positionierten Eingabe-3D-Objekten umfasst.

2. Verfahren nach Anspruch 1, wobei der vorbestimmte Satz von einer oder mehreren gegenseitigen Anordnungsbeziehungen eine Adjazenzbeziehung und/oder eine vertikale Überlagerungsbeziehung umfasst.

3. Verfahren nach Anspruch 1 oder 2, wobei die Paare des Datensatzes Paare umfassen, die ein Dekorationsobjekt und ein Möbelobjekt beinhalten.

4. Verfahren nach einem der Ansprüche 1 bis 3, wobei die Paare des Datensatzes Paare umfassen, die ein Dekorationsobjekt und ein weiteres Dekorationsobjekt beinhalten.

5. Verfahren nach Anspruch 1, wobei für jedes ausgegebene Paar die Informationen bezüglich der relativen Positionierung des ersten realen Objekts und des zweiten realen Objekts in jedem Vorkommen des ausgegebenen Paars eine jeweilige relative Positionierung für jedes Vorkommen umfassen, wobei das Verfahren ferner vor dem relativen Positionieren (S41) für jedes ausgegebene Paar ein Anpassen von Parametern eines Gaußschen Mischmodells an die relative Positionierung von Objekten in den Vorkommen des Paars umfasst, das relative Positionieren (S41) umfassend ein Abtasten in der durch das Gaußsche Mischmodell für die angepassten Parameter dargestellten Verteilung.

6. Verfahren nach einem der Ansprüche 1 bis 5, wobei jedes ausgegebene Paar eine Zählung aufweist, die höher ist als eine vorbestimmte Zahl.

7. Verfahren nach einem der Ansprüche 1 bis 6, wobei jeder Raum des Datensatzes vom gleichen Typ ist wie der durch die Eingabe-3D-Szene dargestellte Raum.

8. Verfahren nach einem der Ansprüche 1 bis 7, wobei das eine oder die mehreren ausgegebenen Paare mehrere ausgegebene Paare umfassen, das Verfahren vor der Positionierung ferner umfassend ein Auswählen durch den Benutzer desjenigen der einen oder mehreren ausgegebenen Paare, aus dem das Eingabe-3D-Objekt positioniert wird.

9. Verfahren nach einem der Ansprüche 1 bis 7, wobei das eine oder die mehreren ausgegebenen Paare mehrere ausgegebene Paare umfassen, das Verfahren vor der Positionierung ferner umfassend ein Einordnen der ausgegebenen Paare entsprechend der Anzahl der ausgegebenen Paare in dem Datensatz, wobei das ausgegebene Paar, aus dem das Eingabe-3D-Objekt positioniert wird, das mit der höchsten Rangfolge ist.

10. Verfahren nach einem der Ansprüche 1 bis 9, wobei das Verfahren nach der Positionierung (S50) des Eingabe-3D-Objekts ferner ein Anzeigen (S60) des positionierten Eingabe-3D-Objekts umfasst.

11. Computerprogramm, umfassend Anweisungen zum Ausführen des Verfahrens nach einem der Ansprüche 1 bis 10.

12. Computerlesbares Speichermedium, auf dem das Computerprogramm nach Anspruch 11 aufgezeichnet ist.

13. System, umfassend einen Prozessor, der mit einem Speicher gekoppelt ist, wobei auf dem Speicher das Computerprogramm nach Anspruch 11 aufgezeichnet ist.

## Revendications

1. Procédé mis en œuvre par ordinateur pour positionner automatiquement un objet 3D d'entrée représentant un objet réel dans une scène 3D d'entrée représentant une pièce, la scène 3D d'entrée comprenant une pluralité d'objets 3D positionnés, la pluralité d'objets 3D positionnés comprenant des objets 3D de mobilier positionnés représentant chacun un meuble réel, le procédé comprenant :
• l'obtention (S10) d'un ensemble de données comprenant des informations concernant des objets d'une pluralité de pièces, les informations comprenant :
∘ une classification des objets de la pluralité de pièces,
∘ des dénombrements de chaque élément de l'ensemble constitué de chaque occurrence d'une paire respective comprenant un même premier objet réel et un même deuxième objet réel dans une pièce, dans lequel le premier objet réel et le deuxième objet réel de chaque occurrence de chaque paire respective sont agencés selon une relation d'agencement mutuel parmi un ensemble prédéterminé d'une ou plusieurs relations d'agencement mutuel, et
∘ des informations concernant le positionnement relatif du premier objet réel et du deuxième objet réel dans chaque occurrence de chaque paire ;
• l'exécution (S20) d'instructions de programme informatique qui amènent à :
∘ tenter d'identifier, dans l'ensemble de données, une ou plusieurs premières paires comprenant chacune l'objet 3D d'entrée et un objet 3D positionné respectif de la scène 3D d'entrée ;
∘ lorsqu'aucune première paire n'est identifiée, tenter d'identifier, dans l'ensemble de données, une ou plusieurs deuxièmes paires comprenant chacune uniquement l'un de l'objet 3D d'entrée et d'un objet 3D positionné respectif de la scène 3D d'entrée, et un objet équivalent pour l'autre, un objet réel donné étant un objet équivalent pour un autre objet réel donné lorsque l'objet réel donné a la même classification que l'autre objet réel donné et que l'objet réel donné est, parmi l'ensemble constitué de chaque objet réel de la même classification présent dans l'ensemble de données, le plus proche en taille de l'autre objet réel donné ;
∘ lorsqu'aucune première paire n'est identifiée et qu'aucune deuxième paire n'est identifiée, tenter d'identifier, dans l'ensemble de données, une ou plusieurs troisièmes paires comprenant chacune un objet équivalent pour l'objet 3D d'entrée et un objet équivalent pour un objet 3D positionné respectif de la scène 3D d'entrée ;
• la fourniture en sortie (S30) d'une ou plusieurs paires parmi l'ensemble constitué de chaque paire identifiée et des dénombrements de la ou des paires identifiées, la fourniture en sortie étant basée sur l'ensemble constitué de chaque dénombrement pour une paire identifiée respective de l'ensemble constitué de chaque paire identifiée ;
• pour chaque paire fournie en sortie, la détermination (S40) d'une position respective de l'objet 3D d'entrée dans la scène 3D d'entrée sur la base des informations concernant le positionnement relatif du premier objet réel et du deuxième objet réel dans chaque occurrence de la paire fournie en sortie, dans lequel, pour chaque paire fournie en sortie, la position respective de l'objet 3D d'entrée dans la scène 3D d'entrée déterminée pour la paire fournie en sortie ne présente aucun conflit avec un autre objet 3D de la pluralité d'objets 3D positionnés de la scène 3D d'entrée, dans lequel la détermination du conflit comprend le fait de :
∘ vérifier qu'une intersection entre l'objet 3D d'entrée et tous les autres objets 3D de la scène d'entrée est nulle, ou
∘ chaque objet 3D de la scène étant représenté par une boîte englobante 3D, calculer le volume de l'intersection de sa boîte englobante avec la boîte englobante de l'objet 3D d'entrée et, s'il est déterminé que le volume de l'intersection est supérieur à un seuil donné, alors, considérer que la collision constitue un conflit et ignorer cette solution,
dans lequel la détermination (S40) de la position respective pour chaque paire fournie en sortie comprend le fait de :
∘ positionner relativement (S41) l'objet 3D d'entrée avec l'autre objet de la paire dans la scène 3D d'entrée sur la base des informations concernant le positionnement relatif du premier objet réel et du deuxième objet réel dans chaque occurrence de la paire fournie en sortie ;
∘ accrocher (S42) l'objet 3D d'entrée positionné relativement sur un élément de la scène 3D, l'accrochage consistant à coller automatiquement l'objet 3D d'entrée sur l'élément de la scène 3D tout en restant dans le positionnement relatif déterminé à l'étape précédente (S41), l'accrochage consistant en outre à déterminer l'élément de la scène 3D sur lequel l'objet 3D d'entrée est accroché, puis à accrocher l'objet 3D d'entrée sur cet élément déterminé, l'élément déterminé dépendant de la catégorie de l'objet 3D d'entrée et étant le plus proche de l'objet 3D d'entrée positionné, et, en fonction de la catégorie déterminée de l'objet 3D d'entrée, l'accrochage consistant à accrocher l'objet 3D d'entrée sur le plafond ou sur le mur le plus proche ou sur la surface horizontale la plus proche pour tenir compte de la gravité, ce qui permet de ne modifier que la coordonnée z de l'objet 3D d'entrée ;
• le positionnement (S50) de l'objet 3D d'entrée selon la position respective déterminée pour l'une de la ou des paires fournies en sortie ;
• l'évaluation d'un ou plusieurs indicateurs de disposition sur la pièce représentée par la scène d'entrée, le ou les indicateurs de disposition comprenant un indicateur de circulation, un indicateur de luminosité, un indicateur d'accessibilité et/ou un indicateur d'ergonomie ;
dans lequel le processus de conception de pièce réelle est répété pour plusieurs objets d'entrée à l'aide desdits indicateurs de disposition évalués, en positionnant différents objets d'entrée à l'intérieur de la scène 3D d'entrée, afin d'assurer la facilité de déplacement, l'accessibilité de certains objets, la sécurité ou un certain niveau d'ergonomie dans la pièce, et le procédé comprend en outre la construction de la pièce selon la scène 3D avec les objets 3D d'entrée positionnés.

2. Procédé selon la revendication 1, dans lequel l'ensemble prédéterminé d'une ou plusieurs relations d'agencement mutuel comprend une relation d'adjacence et/ou une relation de superposition verticale.

3. Procédé selon la revendication 1 ou 2, dans lequel les paires de l'ensemble de données comprennent des paires comprenant un objet décoratif et un objet de mobilier.

4. Procédé selon l'une quelconque des revendications 1 à 3, dans lequel les paires de l'ensemble de données comprennent des paires comprenant un objet décoratif et un autre objet décoratif.

5. Procédé selon la revendication 1, dans lequel, pour chaque paire fournie en sortie, les informations concernant le positionnement relatif du premier objet réel et du deuxième objet réel dans chaque occurrence de la paire fournie en sortie comprennent un positionnement relatif respectif pour chaque occurrence, le procédé comprenant en outre, avant le positionnement relatif (S41) pour chaque paire fournie en sortie, l'ajustement des paramètres d'un modèle de mélange gaussien au positionnement relatif des objets dans les occurrences de la paire, le positionnement relatif (S41) comprenant un échantillonnage dans la distribution représentée par le modèle de mélange gaussien pour les paramètres ajustés.

6. Procédé selon l'une quelconque des revendications 1 à 5, dans lequel chaque paire fournie en sortie a un dénombrement supérieur à un nombre prédéterminé.

7. Procédé selon l'une quelconque des revendications 1 à 6, dans lequel chaque pièce de l'ensemble de données est du même type que la pièce représentée par la scène 3D d'entrée.

8. Procédé selon l'une quelconque des revendications 1 à 7, dans lequel la ou les paires fournies en sortie comprennent plusieurs paires fournies en sortie, le procédé comprenant en outre, avant le positionnement, la sélection par l'utilisateur de l'une de la ou des paires fournies en sortie à partir de laquelle l'objet 3D d'entrée est positionné.

9. Procédé selon l'une quelconque des revendications 1 à 7, dans lequel la ou les paires fournies en sortie comprennent plusieurs paires fournies en sortie, le procédé comprenant en outre, avant le positionnement, le classement des paires fournies en sortie selon le dénombrement des paires fournies en sortie dans l'ensemble de données, la paire fournie en sortie à partir de laquelle l'objet 3D d'entrée est positionné étant celle ayant le classement le plus élevé.

10. Procédé selon l'une quelconque des revendications 1 à 9, le procédé comprenant en outre, après le positionnement (S50) de l'objet 3D d'entrée, l'affichage (S60) de l'objet 3D d'entrée positionné.

11. Programme informatique comprenant des instructions pour mettre en œuvre le procédé selon l'une quelconque des revendications 1 à 10.

12. Support de stockage lisible par ordinateur sur lequel est enregistré un programme informatique selon la revendication 11.

13. Système comprenant un processeur couplé à une mémoire, sur laquelle mémoire est enregistré le programme informatique selon la revendication 11.
